# EUROPEAN PATENT APPLICATION

(11) **EP 4 851 651 A1**
(43) Date of publication of application: **09.12.2026**
(21) Application number: 24927737.7
(22) Date of filing: 04.03.2024
(51) Int. Cl.: G01R 31/66, H04B 1/00, H04B 17/10

(54) **CIRCUIT ASSEMBLY, CIRCUIT DETECTION METHOD, CHIP SYSTEM AND ELECTRONIC DEVICE**

(71) Applicant: Honor Device Co., Ltd., Shenzhen, Guangdong 518040 (CN)
(72) Inventor: ZHANG, Xiangfan, Shenzhen, Guangdong 518040 (CN)
(74) Representative: Henselmann, Alexander Gerhard
(86) International application number: PCT/CN2024/079976
(87) International publication number: WO 2025/184785

(57) **Abstract**

Embodiments of this application provide a circuit assembly, a circuit detection method, a chip system, and an electronic device, and relate to the field of electronic device technologies. Through the method, a mating state of a radio frequency cable can be accurately detected based on USID detection of a MIPI device. The circuit assembly includes: a radio frequency module, an antenna module, and a first radio frequency cable. The antenna module includes at least one MIPI device and at least one antenna. The at least one MIPI device includes a first MIPI device. The at least one antenna includes a first antenna. A first end of the radio frequency module is coupled to a first end of the first radio frequency cable, and a second end of the first radio frequency cable is coupled to a first end of the first MIPI device. A second end of the first MIPI device is coupled to the first antenna. The second end of the first radio frequency cable is further coupled to a first functional pin of the first MIPI device. The first end of the first radio frequency cable is coupled to a reference ground.

## Description

### TECHNICAL FIELD

Embodiments of this application relate to the field of electronic device technologies, and in particular, to a circuit assembly, a circuit detection method, a chip system, and an electronic device.

### BACKGROUND

Currently, a plurality of circuit boards (such as PCBs) may be configured in an electronic device to bear different electronic components. Inter-board signal transmission can be implemented between different circuit boards through a communication cable.

A wireless communication link in the electronic device is used as an example. Components, such as a baseband module and a radio frequency module, and an antenna module in the wireless communication link may be configured on different circuit boards. The radio frequency module and the antenna module may implement inter-board radio frequency signal transmission through a radio frequency cable.

Generally, a female socket may be configured at each of two ends of the radio frequency cable. Correspondingly, a male socket corresponding to the female socket may be configured on the PCB. By mating the female socket with the male socket, the radio frequency cable can be assembled on the PCB. With reference to the foregoing description of radio frequency signal transmission, normal mating between the female socket and the male socket of the radio frequency cable (or referred to as normal mating of the radio frequency cable for short) is a necessary condition for ensuring normal operation of the wireless communication link.

### SUMMARY

This application provides a circuit assembly, a circuit detection method, a chip system, and an electronic device, to accurately detect a mating state of a radio frequency cable based on USID detection of a MIPI device. In this solution, additional communication resources (such as GPIO resources) do not need to be occupied, and excessive wires do not need to be configured in the electronic device to occupy a board area.

To achieve the foregoing technical objective, this application uses the following technical solutions.

According to a first aspect, a circuit assembly is provided, including: a radio frequency module, an antenna module, and a first radio frequency cable. The antenna module includes at least one MIPI device and at least one antenna. The at least one MIPI device includes a first MIPI device. The at least one antenna includes a first antenna. A first end of the radio frequency module is coupled to a first end of the first radio frequency cable, and a second end of the first radio frequency cable is coupled to a first end of the first MIPI device. A second end of the first MIPI device is coupled to the first antenna. The second end of the first radio frequency cable is further coupled to a first functional pin of the first MIPI device. The first end of the first radio frequency cable is coupled to a reference ground.

In this way, by using the circuit assembly provided in the solution, a connection status of the first functional pin of the first MIPI device is associated with a mating state (for example, normal mating or abnormal mating) of the first radio frequency cable. For example, when the first radio frequency cable is normally mated, the first functional pin may be coupled to the reference ground through the first radio frequency cable. In this way, the connection status of the first functional pin is grounded, which corresponds to that the first radio frequency cable is normally mated. For another example, when the first radio frequency cable is abnormally mated, a link between the first functional pin and the reference ground is disconnected at the first radio frequency cable. In this way, the connection status of the first functional pin is floating, which corresponds to that the first radio frequency cable is abnormally mated. Therefore, whether the first radio frequency cable is well mated can be determined by detecting a parameter related to the first functional pin of the first MIPI device.

Optionally, the circuit assembly further includes: a baseband module, and a first register corresponding to the first MIPI device. A first end of the baseband module is coupled to a first end of the first register, and a second end of the baseband module is coupled to a second end of the radio frequency module. A second end of the first register is coupled to a third end of the first MIPI device. When a first USID is the same as a second USID, first written data is the same as first read data. The first USID is a USID corresponding to the connection status of the first functional pin, and the second USID is a corresponding USID when the connection status of the first functional pin is grounded. The first written data is data written into the first register by the baseband module based on the second USID. The first read data is data read by the baseband module from the first register based on the second USID.

Optionally, when the first USID is different from the second USID, the first written data is different from the first read data.

Optionally, the first MIPI device is configured with first device information, and the first device information includes the second USID.

The example provides a specific solution implementation of determining the parameter related to the first functional pin of the first MIPI device. An example in which the parameter related to the first functional pin of the first MIPI device is a USID of the first MIPI device is used. The first USID may be an actual USID of the first MIPI device, and the first USID may be in direct association with the connection status of the first radio frequency cable. For example, if the first radio frequency cable is normally mated, the first USID corresponds to that the connection status is grounded. For another example, if the first radio frequency cable is abnormally mated, the first USID corresponds to that the connection status is floating. The example further provides a solution implementation of determining, based on a comparison of a read value and a written value of the register, whether the first USID is the same as the second USID in a default condition (for example, in a grounded state).

Therefore, whether the first radio frequency cable is well mated may be determined by determining whether the first written data is the same as the first read data.

Optionally, the first device information further includes: information about a MIPI bus interface of the first MIPI device, and an identifier of a first register address of the first MIPI device.

Optionally, before the baseband module writes the first written data into the first register, the baseband module is further configured to search for the first register based on the first device information. The baseband module writes the first written data into the first register when the first register is found. When the first USID is the same as the second USID, it is determined that the first register is found.

Optionally, after the baseband module writes the first written data into the first register, and before the baseband module reads the data from the first register, the baseband module is further configured to search for the first register based on the first device information. The baseband module reads written data from the first register when the first register is found, and the written data is the first read data. When the first USID is the same as the second USID, it is determined that the first register is found.

Optionally, when the first USID in the first register is different from the second USID, the first read data read by the baseband module includes: an identifier of 0 or false.

Optionally, the circuit assembly further includes a first capacitor and a second capacitor. The first end of the radio frequency module is coupled to the first end of the first radio frequency cable through the first capacitor, and the second end of the first radio frequency cable is coupled to the first end of the first MIPI device through the second capacitor.

Therefore, normal transmission of a radio frequency signal is implemented by configuring a capacitor on a radio frequency signal transmission link. Because of a characteristic of blocking direct current by the capacitor, a direct current signal sent by a USID pin does not enter the radio frequency module or the antenna by mistake.

Optionally, the circuit assembly further includes a first inductor and a second inductor. The second end of the first radio frequency cable is coupled to the first functional pin of the first MIPI device through the first inductor. The first end of the first radio frequency cable is coupled to the reference ground through the second inductor.

Therefore, by configuring an inductor on a USID connection link, normal transmission of a direct current signal on the USID connection link is implemented. Because of a characteristic of blocking alternating current by the inductor, a case that a radio frequency signal is grounded by mistake is avoided.

In this application, a circuit assembly connection manner in a case of a multi-channel radio frequency cable connection is further provided, so that a mating state of two or more radio frequency cables can be detected through the first MIPI device.

Optionally, the circuit assembly further includes a second radio frequency cable, and the at least one antenna further includes a second antenna. A third end of the radio frequency module is coupled to a first end of the second radio frequency cable, and a second end of the second radio frequency cable is coupled to the second antenna. The second end of the second radio frequency cable is further coupled to the reference ground. The first end of the second radio frequency cable is coupled to the first end of the first radio frequency cable. That the first end of the first radio frequency cable is coupled to a reference ground includes: the first end of the first radio frequency cable being coupled to the reference ground through the second radio frequency cable.

Optionally, the circuit assembly further includes a third capacitor and a fourth capacitor, and the third end of the radio frequency module is coupled to the first end of the second radio frequency cable through the third capacitor. The second end of the second radio frequency cable is coupled to the second antenna through the fourth capacitor.

Optionally, the circuit assembly further includes a third inductor and a fourth inductor, and the first end of the second radio frequency cable is coupled to the first end of the first radio frequency cable through the third inductor. The second end of the second radio frequency cable is further coupled to the reference ground through the fourth inductor.

According to a second aspect, a circuit detection method is provided. The method is applied to an electronic device. The electronic device is configured with the circuit assembly according to the first aspect and any possible design thereof. The method includes: obtaining first device information, where the first device information is device information of the first MIPI device; writing first written data into the first register based on the first device information, where the first register corresponds to the first MIPI device; reading data in the first register based on the first device information, to obtain first read data; when the first written data is the same as the first read data, determining that the first end of the first radio frequency cable is coupled to the radio frequency module; and the second end of the first radio frequency cable being coupled to a first port of the first MIPI device; or when the first written data is different from the first read data, determining that the first end of the first radio frequency cable is disconnected from the radio frequency module, and/or the second end of the first radio frequency cable is disconnected from the first port of the first MIPI device.

It may be understood that, the solution implementation provided in the second aspect may be used for detecting a mating state of the first radio frequency cable. With reference to the description of the solution of the first aspect, when the hardware configuration in this application is used in detection of a mating state of two or more radio frequency cables, a corresponding method may be correspondingly adjusted.

According to a third aspect, an electronic device is provided. The electronic device is configured with the circuit assembly according to the first aspect and any possible design thereof.

Optionally, the electronic device may perform the method provided in the second aspect based on the configured circuit assembly. For example, the mating state of the radio frequency cable is detected.

According to a fourth aspect, this application further provides an electronic device, including: a memory and one or more processors. The memory is coupled to the processor. The memory is configured to store computer program code, the computer program code includes computer instructions, and the computer instructions, when executed by the processor, cause the electronic device to perform the technical solution provided in the second aspect.

According to a fifth aspect, this application further provides a chip system, applied to an electronic device. The chip system may include one or more interface circuits and one or more processors. The interface circuit is connected to the processor through a line. The interface circuit is configured to receive a signal from a memory of the electronic device, and send the signal to the processor. The signal includes computer instructions stored in the memory. When the processor executes the computer instructions, the electronic device performs the technical solution provided in the second aspect.

Optionally, the chip system may correspond to a baseband processor or modem configured in the electronic device.

According to a sixth aspect, this application further provides a computer-readable storage medium, including computer instructions. The computer instructions, when run on an electronic device, cause the electronic device to perform the technical solution provided in the second aspect and any possible implementation thereof.

According to a seventh aspect, this application further provides a computer program product. The computer program product, when run on a computer, causes the computer to perform the technical solution provided in the second aspect or any possible implementation thereof.

It may be understood that, the solutions provided in the second aspect to the seventh aspect of this application may respectively correspond to the first aspect and any possible design thereof. Therefore, beneficial effects that can be achieved are similar. Details are not described herein again.

### BRIEF DESCRIPTION OF DRAWINGS

FIG. 1 is a schematic diagram of an internal component configuration of an electronic device according to an embodiment of this application;
FIG. 2 is a schematic diagram of composition of an antenna module according to an embodiment of this application;
FIG. 3 is a schematic diagram of connection logic of a radio frequency module, a baseband module, and an antenna module according to an embodiment of this application;
FIG. 4 is a schematic diagram of comparison of hardware states of a MIPI device according to an embodiment of this application;
FIG. 5 is a schematic diagram of configuration of different modules on a plurality of PCBs in an electronic device according to an embodiment of this application;
FIG. 6 is a schematic diagram of an internal component configuration of an electronic device according to an embodiment of this application;
FIG. 7 is a schematic diagram of connection of components in an electronic device according to an embodiment of this application;
FIG. 8 is a schematic diagram of a circuit assembly according to an embodiment of this application;
FIG. 9 is a schematic diagram of comparison of different signal flow paths according to an embodiment of this application;
FIG. 10 is a schematic flowchart of a method for detecting a mating state of a radio frequency cable according to an embodiment of this application;
FIG. 11 is a schematic diagram of an AT command according to an embodiment of this application;
FIG. 12 is a schematic diagram of an AT command according to an embodiment of this application;
FIG. 13 is a schematic diagram of a circuit assembly according to an embodiment of this application;
FIG. 14 is a schematic diagram of a logic circuit corresponding to a USID signal in different cases according to an embodiment of this application;
FIG. 15 is a schematic diagram of a circuit assembly according to an embodiment of this application;
FIG. 16 is a schematic diagram of a logic circuit corresponding to a USID signal in different cases according to an embodiment of this application;
FIG. 17 is a schematic diagram of logic of circuit connection in an existing solution;
FIG. 18 is a schematic diagram of composition of an electronic device according to an embodiment of this application; and
FIG. 19 is a schematic diagram of composition of a chip system according to an embodiment of this application.

### DESCRIPTION OF EMBODIMENTS

The terms "first" and "second" mentioned below are used merely for the purpose of description, and shall not be construed as indicating or implying relative importance or implicitly implying a quantity of indicated technical features. Therefore, a feature limited by "first" or "second" may explicitly or implicitly include one or more features. In the descriptions of embodiments, unless otherwise specified, "a plurality of" means two or more.

Currently, an electronic device can implement a wireless communication function through a component configured in the electronic device.

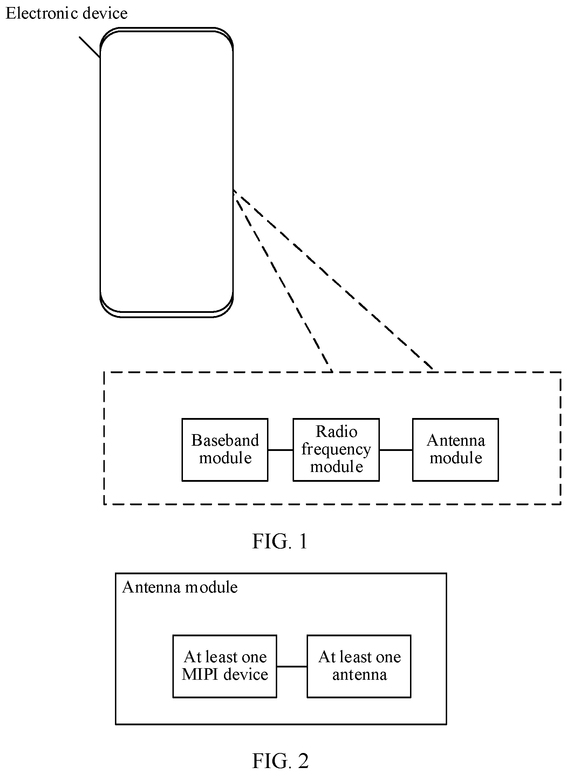

For example, refer to FIG. 1. The electronic device may be configured with a baseband module, a radio frequency module, and an antenna module. The baseband module, the radio frequency module, and the antenna module are sequentially coupled.

In embodiments of this application, coupling may be used for representing a connection manner of electrical connection. Specific implementations may include forms such as direct electrical connection and coupled electrical connection. In a form of coupling, signal transmission between two modules may be implemented.

In the example shown in FIG. 1, the baseband module may be configured to provide a digital processing capability in the wireless communication function. In some implementations, the baseband module may include a modem (Modem), and/or a peripheral circuit implementing a digital processing function.

The radio frequency module may be configured to provide a radio frequency processing capability in the wireless communication function. The radio frequency processing is processing on an analog signal. In some implementations, the radio frequency module may include a radio frequency processing device such as a radio frequency amplifier and a circuit.

It may be understood that the baseband module may process a digital signal. The radio frequency module may process a radio frequency signal (that is, the analog signal). In this way, to ensure normal operation of the baseband module and the radio frequency module, an analog-to-digital (AD) conversion component may be further configured in the electronic device. The AD conversion component may be configured to perform conversion between the analog signal and the digital signal.

A transmission scenario is used as an example. After processing the digital signal, the baseband module may convert the digital signal into the analog signal through the AD conversion component. The analog signal may be transmitted to the radio frequency module for radio frequency processing.

A receiving scenario is used as an example. The radio frequency module may convert the analog signal into the digital signal through the AD conversion component after performing radio frequency processing on a received signal. The digital signal may be transmitted to the baseband module for digital processing.

In some implementations, the AD conversion component may be independent of the baseband module and the radio frequency module, and may be configured in series between the baseband module and the radio frequency module. In some other implementations, the AD conversion component may be integrated in the baseband module or the radio frequency module.

As shown in FIG. 1, the radio frequency module may be further coupled to the antenna module. The antenna module may include one or more antennas. Operating frequency bands covered by different antennas may be the same or may not be completely the same. The antenna module may provide a conversion capability between an analog signal and an electromagnetic wave through one or more antennas.

Signal sending is used as an example. The antenna module may radiate the radio frequency signal from the radio frequency module in a form of an electromagnetic wave, to implement signal sending.

Signal receiving is used as an example. The antenna module may receive an electromagnetic wave in space, and generate a corresponding analog signal. The antenna module may transmit the analog signal to the radio frequency module, so that the radio frequency module and the baseband module perform subsequent processing.

As shown in FIG. 2, in some embodiments, the antenna module may further include one or more tuners (tuners).

The electronic device may control conduction of different paths in the tuner, so that the antenna operates in different operating states, or a different antenna is switched for operation. Further, flexible adjustment during operation of the antenna is implemented.

According to different control signal types, the tuner may include a tuner controlled by a mobile industry processor interface (Mobile Industry Processor Interface, MIPI) signal, and a tuner controlled by a general-purpose input/output (General-purpose input/output, GIPO) signal.

The tuner controlled by the MIPI signal may also be referred to as a MIPI device for short. The tuner controlled by the GPIO signal may also be referred to as a GPIO device for short.

For the MIPI device, accurate switching of the operating state of the antenna by the MIPI device can be implemented through a targeted connection configuration of a plurality of pins on the MIPI device.

It should be noted that, in the following descriptions, an example in which the antenna module includes at least one MIPI device and at least one antenna is used. One antenna may be coupled to one or more corresponding MIPI devices, to form one antenna path in the antenna module. In some other implementations, the antenna may not be coupled to the radio frequency module through the MIPI device. In this way, the antenna path may not include the MIPI device.

For example, an example in which the at least one antenna includes an antenna 1, and a MIPI device coupled to the antenna 1 includes a MIPI device A is used. An antenna path 1 corresponding to the antenna 1 may include the antenna 1 and the MIPI device A configured to perform state switching.

The antenna path 1, the radio frequency module, and a communication connection line between the antenna path 1 and the radio frequency module may form an analog signal communication link 1 corresponding to the antenna 1, which is referred to as an analog link 1 for short.

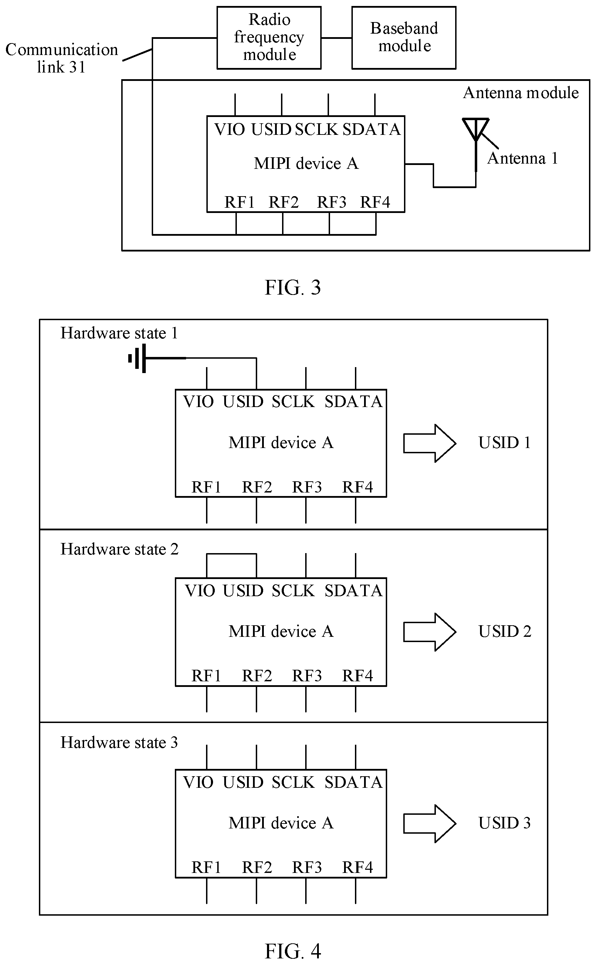

For example, refer to FIG. 3. By using the MIPI device A on the antenna path 1 as an example, pin disposition and connection conditions of the MIPI device are briefly described.

As shown in FIG. 3, the MIPI device A may include a plurality of pins. The plurality of pins may include one or more radio frequency signal pins, a power supply pin, a control pin, and the like.

In the example, the MIPI device A may include four radio frequency pins. For example, RF1, RF2, RF3, and RF4 are provided. In some implementations, different sizes or types of tuners (such as an inductor and a capacitor) may be correspondingly configured on different pins. It may be understood that, in some other implementations, a quantity of the radio frequency pins of the MIPI device may be greater than 4 or less than 4. This is not limited in embodiments of this application.

The power supply pin of the MIPI device A may have a VIO identifier, and may also be referred to as a VIO pin. By coupling the VIO pin to a power supply component, power supply to the MIPI device A may be implemented, so that the MIPI device A operates normally.

The control pin of the MIPI device A may include an SDATA pin, an SCLK pin, and the like. The SDATA pin may be configured to transmit a control command (such as the MIPI signal). The SCLK pin may be configured to transmit a synchronization clock signal, and the like.

FIG. 3 further provides a logical connection relationship between the antenna component and another component such as the radio frequency component when the antenna component includes the MIPI device A.

It should be noted that in the logical connection shown in FIG. 3, a connection of the radio frequency pin is mainly used as an example. A connection manner of other pins of the MIPI device A during actual configuration is not shown in FIG. 3. The connection manner of the other pins (such as the VIO pin and the control pin) may be correspondingly performed based on an actual function. Details are not described herein again.

As shown in FIG. 3, when the radio frequency module is coupled to the antenna module, the radio frequency module may be specifically coupled to RF1, RF2, RF3, and RF4. For example, the radio frequency module may be separately connected to RF1, RF2, RF3, and RF4 through a communication link 31.

In this way, in the transmission scenario, the radio frequency signal may be transmitted to any one or more radio frequency pins through the communication link 31. Further, the radio frequency is transmitted to the antenna 1 through the conducted radio frequency pin for radiation. Corresponding to the receiving scenario, the antenna 1 may convert the received electromagnetic wave into the analog signal, and the analog signal may be transmitted by the conducted radio frequency pin to the radio frequency module through the communication link 31 for subsequent processing.

It should be noted that when the MIPI device operates, the electronic device may control, through the MIPI signal, each radio frequency pin in the MIPI device to be in a turned-on or turned-off state, thereby implementing conduction control on the radio frequency pins (for example, RF1 to RF4), and further switching the operating state of the antenna.

In an example, the electronic device may transmit a MIPI signal 1 to the SDATA pin of the MIPI device A, instructing to turn on RF1 while keeping other radio frequency pins disconnected. Correspondingly, the MIPI device A may configure RF1 to be in a conducted state based on the MIPI signal 1. In this way, during signal transmission and reception, the signal can be transmitted to and from the antenna 1 via a path corresponding to RF1 after passing through the communication link 31.

It may be understood that a matching device different from the another radio frequency pin may be configured on the path corresponding to RF1. Therefore, by controlling RF1 to be turned on, the matching device on the path of RF1 can correspondingly modulate the radio frequency signal, so that the analog signal transmitted to the antenna 1 matches characteristics (such as a resistance characteristic) of the antenna 1 in the operating state. In this way, the antenna 1 is controlled to operate in the operating state corresponding to RF1.

Based on a similar solution implementation, the electronic device may further control, through the MIPI signal, the another radio frequency pin to be turned on or turned off, so that the antenna 1 operates in another configured operating state.

In addition, as shown in FIG. 3, the pins of the MIPI device (such as the MIPI device A) may further include a unique slave identifier (Unique Slave ID, USID) pin.

It may be understood that the MIPI device may be addressed by using a USID. When a plurality of MIPI devices are configured in the electronic device, USIDs of different MIPI devices may be different. In this way, the electronic device can uniquely identify a MIPI device by using information such as the USID.

During specific implementation, a hardware state of the USID pin may correspondingly represent a USID of the MIPI device.

In this application, the hardware state of the USID pin is a connection status of the USID pin. For example, the connection status may include being floating, being grounded, being connected to the VIO pin, and the like. During actual implementation, the hardware state of the USID pin may be any one of the foregoing three states. Therefore, a USID may be selectively configured for the MIPI device A through hardware state configuration.

In an example, as shown in FIG. 4, the hardware state of the USID pin may include being floating, being grounded, being connected to the VIO pin, and the like.

When the USID pin is grounded, the hardware state of the USID pin may correspond to a hardware state 1. The hardware state 1 may correspond to configuring the USID of the MIPI device A as a USID 1.

When the USID pin is connected to the VIO pin, the hardware state of the USID pin may correspond to a hardware state 2. The hardware state 2 may correspond to configuring the USID of the MIPI device A as a USID 2.

When the USID pin is floating, the hardware state of the USID pin may correspond to a hardware state 3. The hardware state 3 may correspond to configuring the USID of the MIPI device A as a USID 3.

In this way, during hardware design, configuration of the USID of the MIPI device may be implemented by configuring the hardware state of the USID pin.

The foregoing FIG. 1 to FIG. 4 briefly describe the components on the link for implementing wireless communication.

Correspondingly, in a specific electronic device, a baseband module, a radio frequency module, and an antenna module may be configured on components such as a printed circuit board (printed circuit board, PCB) and a flexible printed circuit (Flexible Printed Circuit, FPC) in the electronic device. The modules are coupled to the components through the communication connection line.

An example in which two PCBs (for example, PCB1 and PCB2) are configured in the electronic device, the baseband module and the radio frequency module are configured on PCB1, and the antenna module is configured on PCB2 is used.

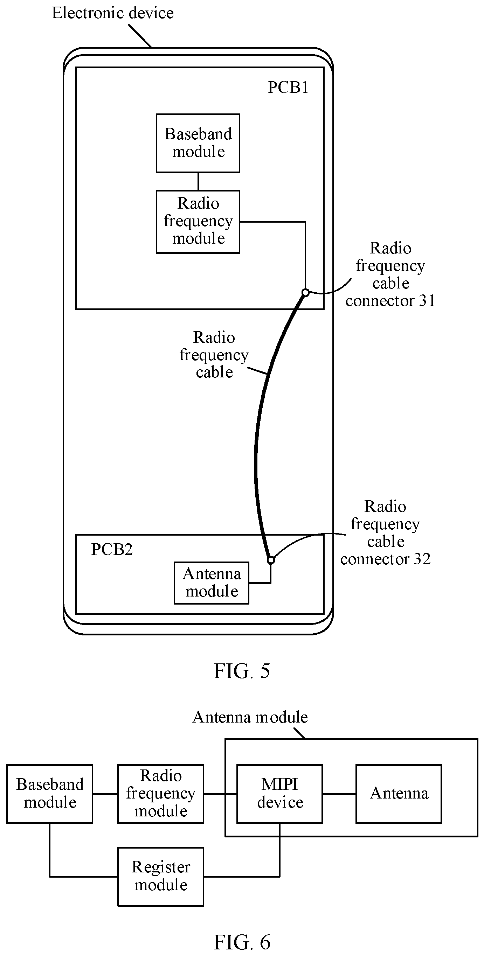

Refer to FIG. 5. The radio frequency module and the baseband module are configured on a same PCB. In this case, the radio frequency module may be coupled to the baseband module through an on-board wire. The radio frequency module and the antenna module are located on different PCBs. In this case, an electrical connection between the radio frequency module and the antenna module may be implemented through configuration of a radio frequency cable (RF cable).

In a possible implementation, a radio frequency cable connector 31 may be configured on PCB1. The radio frequency cable connector 31 may be coupled to the radio frequency module.

A terminal at one end of the radio frequency cable is electrically connected to the radio frequency cable connector 31 in a form of mating.

Similarly, a radio frequency cable connector 32 may be configured on PCB2. The radio frequency cable connector 32 may be coupled to the antenna module. For example, the radio frequency cable connector 32 may be respectively coupled to RF1 to RF4 of the MIPI device A in the antenna module.

A terminal at the other end of the radio frequency cable is electrically connected to the radio frequency cable connector 32 in a form of mating.

In this way, the radio frequency signal may implement signal flow between the radio frequency module and the antenna module through the radio frequency cable.

Corresponding to the example in FIG. 3, the communication link 31 between the radio frequency module and the antenna module (or the MIPI device in the antenna module) can be implemented through cooperation of a plurality of different signal transmission lines. For example, the communication link 31 may include an on-board wire between the radio frequency module on PCB1 and the radio frequency cable connector 31, the radio frequency cable, an on-board wire between the antenna module on PCB2 and the radio frequency cable connector 32, and the like.

It may be understood that normal transmission of the analog signal between the radio frequency module and the antenna 1 can be ensured only when the communication link 31 is normally conducted. However, in a scenario (such as the scenario in FIG. 5) with a plurality of PCBs, a signal needs to flow between a plurality of different communication connection lines, which increases a probability that the communication link 31 cannot be normally conducted. For example, that the radio frequency cable is not well mated, the radio frequency cable is disconnected, and the like affects normal operation of the communication link 31. In the following descriptions, cases such as good mating of the radio frequency cable and disconnection of the radio frequency cable may all be referred to as abnormal mating of the radio frequency cable.

In an existing solution, to accurately detect whether the radio frequency cable is normally mated, an additional detection circuit or component usually needs to be configured on the PCB. In some detection processes, a limited control signal path (for example, a GPIO path) in the electronic device further needs to be occupied. This may negatively affect fine design of the electronic device and space configuration on the PCB.

According to the technical solutions provided in embodiments of this application, a connection manner of an existing device (for example, the MIPI device) can be adjusted, to accurately detect whether the radio frequency cable is normally mated without significantly occupying a PCB area or controlling a signal line.

In some scenarios, the solution may be applied to a related detection process of radio frequency cable mating in an electronic device production process. In some other scenarios, the solution may be applied to a self-performed detection process of an electronic device after the electronic device leaves the factory.

The solution provided in embodiments of this application is described below in detail with reference to the accompanying drawings.

It should be noted that in embodiments of this application, the electronic device may further configure a register for each MIPI device. The register may provide a device information storage capability. The registers of the MIPI devices may form a register module.

In some embodiments, the register module may correspond to an independent storage device. The registers of the MIPI devices may respectively correspond to one storage area in the storage device. In some other embodiments, the register module may alternatively correspond to a set of a plurality of storage devices. In some other embodiments, a function of the register module may alternatively be implemented through the data storage capability of the existing device. For example, the function of the register module may be implemented through an on-chip storage part of the baseband module.

In an example, refer to FIG. 6. With reference to the descriptions in FIG. 1 to FIG. 5, in the example in FIG. 6, in addition to being coupled to the radio frequency module, the MIPI device may be coupled to the register module. The register module may further be coupled to the baseband module.

As described above, corresponding storage space may be configured for each MIPI device in the register module.

For example, an example in which the configured MIPI devices in the electronic device include a MIPI device A, a MIPI device B, a MIPI device C, and a MIPI device D is used. A register A corresponding to the MIPI device A, a register B corresponding to the MIPI device B, a register C corresponding to the MIPI device C, a register D corresponding to the MIPI device D, and the like may be configured in the register module.

In some implementations, the baseband module may maintain correspondence between device information of the MIPI device and a corresponding register module. In this way, the baseband module may learn a register corresponding to the MIPI device in the registers through the device information of the MIPI device, and perform a data read/write operation on the storage space. The data read/write process may be used for detecting whether the MIPI device operates normally.

The device information of the MIPI device may include: a unique slave identifier (Unique Slave ID, USID) of the MIPI device, a MIPI bus interface (or referred to as a MIPI port), a register address, and the like.

Optionally, the device information of the MIPI device may further include: a product identifier (Product ID, PID), a manufacturer identifier (Manufacturer ID, MID), and the like.

It may be understood that, in the device information, the MID is used for identifying a manufacturer corresponding to a current MIPI device, and the PID is a unique identifier configured by the manufacturer for the current MIPI device. The USID is used for addressing the MIPI device.

After the electronic device completes assembly of the MIPI device, the electronic device may configure a MIPI bus interface for each MIPI device, to obtain related information of the MIPI device through the MIPI bus interface.

In this application, when a plurality of MIPI devices are configured in the electronic device, the device information for different MIPI devices includes at least one different item.

For example, USIDs of two different MIPI devices may be configured to be the same, and MIPI ports and register addresses may configured to be different. For another example, two different MIPI devices have different USIDs, MIPI ports, and register addresses. In this way, the electronic device (for example, the baseband module in the electronic device) may distinguish, based on the device information, between registers corresponding to different MIPI devices.

In an example, the following Table 1 provides an example of device information of MIPI devices that are configured in an electronic device. The device information shown in Table 1 may be read by the baseband module.

**Table 1**

| MIPI device | MIPI bus interface | USID | Register address |
|---|---|---|---|
| MIPI device A | 10 | 0, 6 | 0 |
| MIPI device B | 11 | 0, 7 | 1 |
| MIPI device C | 13 | 0, 6 | 3 |
| MIPI device D | 21 | 2, 3 | 5 |
| ... | ... | ... | ... |

In the example in Table 1, the currently configured MIPI devices may include device information of devices such as the MIPI device A, the MIPI device B, the MIPI device C, and the MIPI device D.

A MIPI bus interface corresponding to the MIPI device A is "10", a USID is "0, 6", and an identifier of a register address is "0".

A MIPI bus interface corresponding to the MIPI device B is "11", a USID is "0, 7", and an identifier of a register address is "1".

A MIPI bus interface corresponding to the MIPI device C is "13", a USID is "0, 6", and an identifier of a register address is "3".

A MIPI bus interface corresponding to the MIPI device D is "21", a USID is "2, 3", and an identifier of a register address is "5". The rest may be deduced by analogy.

It should be noted that, in some other implementations, the USID may correspond to a latter configuration value in the foregoing Table 1. For example, the USID of the MIPI device A may be configured as 6. The USID of the MIPI device B may be configured as 7, and the like.

The baseband module may learn a register of each MIPI device based on the device information of the MIPI device shown in Table 1. Further, the baseband module may determine, by performing a data read/write operation on the register of the MIPI device, whether the MIPI device operates normally. An example in which the baseband module determines whether the MIPI device A operates normally is used.

The baseband module may write test data W1 into the corresponding register A based on the device information of the MIPI device A. The baseband module may further read, from the corresponding register A based on the device information of the MIPI device A, test data R1 stored in the register A.

When the read test data R1 is the same as the written test data W1, it indicates that the foregoing data writing process may be normally implemented, which corresponds to that the MIPI device A operates normally. On the contrary, when the read test data R1 is different from the written test data W1, it indicates that the foregoing data writing process cannot be normally implemented, which corresponds to that the MIPI device A works abnormally.

Still refer to the example in FIG. 6. The MIPI device may alternatively be coupled to the register. For example, each MIPI device may have a coupling relationship with a register corresponding to the MIPI device. For example, the MIPI device A is coupled to the register A, and the MIPI device B is coupled to the register B.

In this way, when the device information on the MIPI device side changes, information corresponding to the register also changes. For example, when the USID of the MIPI device changes, an actual USID of the corresponding register also changes.

For example, the MIPI device A is used as an example. Reference may be made to an example of the hardware state of the MIPI device in FIG. 4.

In some cases, a USID pin of the MIPI device A is in the hardware state 1. An example in which the hardware state 1 corresponds to a USID value of [0, 6] is used. Therefore, the actual USID corresponding to the register A may be [0, 6].

In this way, the baseband module may accurately obtain a position of the register A based on the information such as the USID [0, 6], and the register address and the MIPI port of the MIPI device A. Further, the baseband module may perform a data write/read operation on the register A.

In some other cases, the hardware state of the USID pin of the MIPI device A changes, for example, changes from the hardware state 1 to the hardware state 3. An example in which the hardware state 3 corresponds to a USID value of [0, 7] is used. Therefore, the actual USID corresponding to the register A may be changed from [0, 6] to [0, 7].

In this way, the baseband module cannot accurately obtain the position of the register A based on the information such as the configured USID [0, 6], and the register address and the MIPI port of the MIPI device A. Therefore, when the baseband module attempts to write the test data W1 into the register A, the test data W1 cannot be successfully written into the register A. Afterwards, when the baseband module attempts to read the data from the register A, because the position of the register A cannot be accurately obtained, the test data R1 cannot be read. For example, the test data R1 read by the baseband module may be null or 0. An example in which the test data W1 is not 0 is used. The read test data R1 (for example, "0") is different from the written test data W1.

In other words, the baseband module may attempt to write data into the register A based on the device information (such as the USID) of the configured MIPI device, and then attempt to read data from the register A. If the read data (for example, the test data R1) is the same as the written data (for example, the test data W1), it indicates that the actual UISD information of the MIPI device is the same as the configured USID. In other words, it corresponds to that the MIPI device A operates normally. If the read data (for example, the test data R1) is different from the written data (for example, the test data W1), it indicates that the actual UISD information of the MIPI device is different from the configured USID. In other words, it corresponds to that the MIPI device A operates abnormally.

In embodiments of this application, a targeted circuit design of the MIPI device may be used, so that the hardware state of the USID pin corresponding to the MIPI device is different in a case that whether the radio frequency cable is normally mated. Therefore, a current mating state of the radio frequency cable may be identified through the USID.

For example, with reference to the foregoing descriptions, when the test data R1 read by the baseband module is the same as the written test data W1, it corresponds to that the actual USID of the current MIPI device is the same as the configured USID. Correspondingly, the baseband module may determine that the radio frequency cable corresponding to the current MIPI device is normally mated.

For another example, when the test data R1 read by the baseband module is different from the written test data W1, it corresponds to that the actual USID of the current MIPI device is different from the configured USID. Therefore, it indicates that the hardware state of the USID pin of the MIPI device changes due to abnormal mating of the radio frequency cable. Correspondingly, the baseband module may determine that the radio frequency cable corresponding to the current MIPI device is abnormally mated.

Based on this, the electronic device can quickly and accurately detect the mating state of the radio frequency cable.

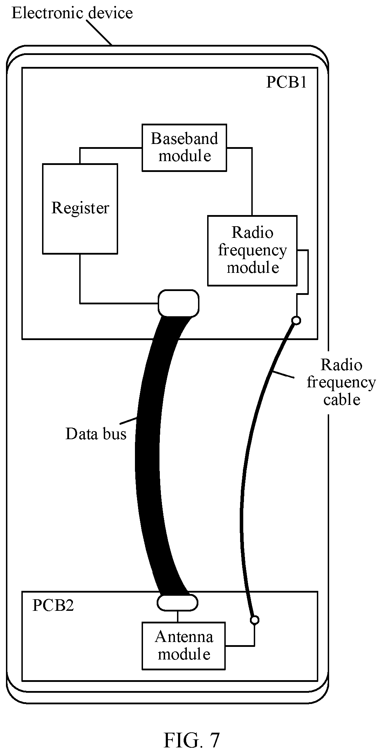

It should be noted that FIG. 6 provides an example of a logical connection relationship between the components. Refer to FIG. 7. FIG. 7 provides an example in which components are configured and connected in an electronic device.

With reference to the description of FIG. 5, refer to FIG. 7. In the electronic device, the baseband module and the radio frequency module may be configured on PCB1. The register may also be configured on PCB1. In this way, the baseband module may attempt to, based on the configured device information, perform a data read/write operation on the register of the MIPI device through the communication connection line between the baseband module and the register.

In this example, the antenna module may be configured on PCB2. Therefore, similar to the example in FIG. 5, the antenna module (for example, the MIPI device in the antenna module) may be communicatively connected to the radio frequency module on PCB1 through the radio frequency cable.

In addition, the MIPI device in the antenna module may further be coupled to the register through a data bus. In this way, when a hardware state of a USID pin of a MIPI device on PCB2 changes, a USID configuration of a corresponding register may also correspondingly change.

For example, when the radio frequency cable is normally mated, the USID pin of the MIPI device in the antenna module corresponds to one hardware state. When the radio frequency cable is abnormally mated, the USID pin of the MIPI device in the antenna module corresponds to another hardware state.

Therefore, when the radio frequency cable is normally mated or abnormally mated, an actual USID value of a register corresponding to the MIPI device also changes. With reference to the foregoing mechanism of performing a data read/write operation by the baseband module on the register, detection of mating of the radio frequency cable can be implemented based on the MIPI device in the antenna module without additionally adding a communication wire or device.

In embodiments of this application, through targeted configuration on the communication link (for example, the communication link 31 shown in FIG. 3) between the USID pin, the radio frequency module, and the antenna module, the hardware state of the USID pin of the MIPI device may correspond to a mating state of the radio frequency cable on the communication link 31.

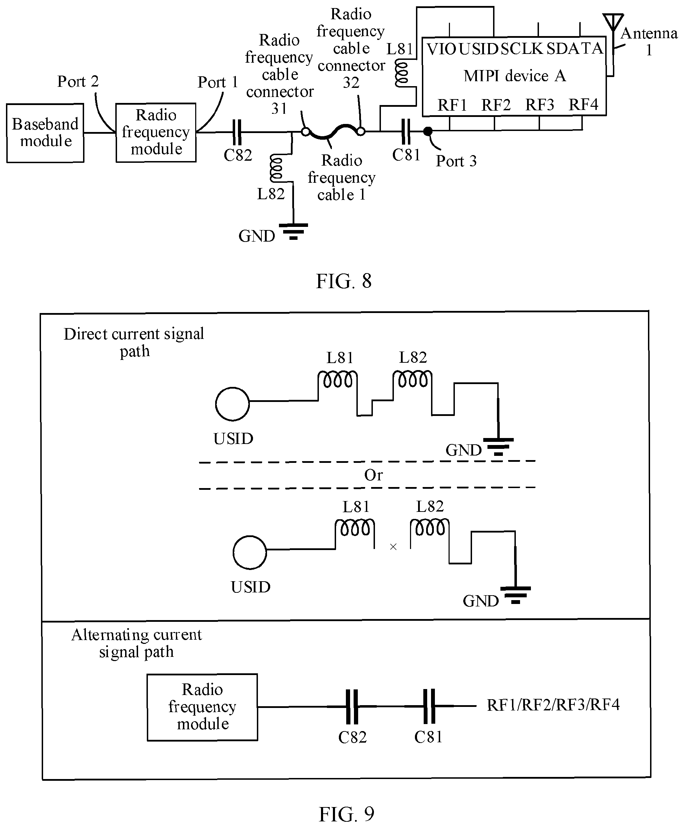

In an example, refer to FIG. 8. FIG. 8 is a schematic diagram of a circuit assembly according to an embodiment of this application.

On PCB1, a baseband module may be coupled to a radio frequency module port 1. A radio frequency module port 2 is coupled to a radio frequency cable connector 31. Only at least one capacitor C82 may be connected in series and at least one inductor L82 may be connected in parallel between the radio frequency module port 2 and the radio frequency cable connector 31.

On PCB2, a MIPI device A in an antenna component may include a port 3. The port 3 may be correspondingly connected to each RF pin of the MIPI device A. The port 3 is coupled to a radio frequency cable connector 32. There may be only at least one capacitor C81 in series between the port 3 and the radio frequency cable connector 32. In addition, a USID pin of the MIPI device A may be connected to the radio frequency cable connector 32 through at least one inductor L81.

A radio frequency cable 1 may be disposed between PCB1 and PCB2. One end of the radio frequency cable 1 is mated with the radio frequency cable connector 31, and the other end of the radio frequency cable 1 is mated with the radio frequency cable connector 32. Therefore, a radio frequency signal flows between PCB1 and PCB2.

Therefore, in the example in FIG. 8, by disposing the inductor L81, a hardware state of the USID pin of the MIPI device A can be associated with a mating state of the radio frequency cable 1.

It may be understood that, in some implementations, the hardware state of the USID pin may be represented through a direct current signal. For example, refer to FIG. 9. The MIPI device A may send a direct current signal. When the direct current signal can be directly grounded, a level at a position corresponding to the USID pin is a low level. It indicates that the USID pin is in a hardware state 1. Correspondingly, when the direct current signal is not grounded (for example, when the radio frequency cable 1 is disconnected), a level at a position corresponding to the USID pin is a high level. It indicates that the USID pin is in a hardware state 3.

Corresponding to the direct current signal that corresponds to the hardware state, the radio frequency signal transmitted between the radio frequency module and the antenna module may be an alternating current signal (for example, a sinusoidal signal) varying periodically. In this way, the alternating current signal corresponding to the radio frequency signal may flow to/from the RF port through the radio frequency module, the capacitor C82, and the capacitor C82 shown in FIG. 9.

In this application, it is based on a characteristic of passing direct current and blocking alternating current (that is, passing DC and blocking AC) by the inductor and a characteristic of passing alternating current and blocking direct current (that is, passing AC and blocking DC) by the capacitor. Through configuration of the capacitor C81 and the capacitor C82, the radio frequency signal may flow between the radio frequency module and the RF port through the capacitor C81 and the capacitor C82, and may not be grounded or enter the USID pin. Correspondingly, through configuration of the inductor L81 and the inductor L82, a direct current signal at the USID pin may be transmitted through the inductor L81 and the inductor L82 without entering an RF port of the radio frequency module or the antenna component.

In this way, the USID pin may be in different hardware states in a case that whether the radio frequency cable 1 is normally mated. An actual USID value of a register A corresponding to the MIPI device A is correspondingly changed in a case that the radio frequency cable 1 is normally mated/abnormally mated. Therefore, through the USID value of the register A, the mating state of the radio frequency cable 1 can be correspondingly indicated.

Further, a USID value of the register A that is configured by the baseband module may be a USID value corresponding to a hardware state in a case that the radio frequency cable 1 is normally mated. Therefore, in a case that the baseband module can normally perform a test data read/write operation based on a configured USID value, the actual USID value of the corresponding register A is the same as the configured USID value. Further, it is determined that the hardware state of the USID pin of the MIPI device A corresponds to the hardware state in a case that the radio frequency cable 1 is normally mated. In this way, the baseband module may determine that the radio frequency cable 1 on the link corresponding to the MIPI device A is normally mated.

It should be noted that in the example in FIG. 8, the radio frequency cable connector 32 is coupled to the MIPI device A through the C81 and the L81, to implement a signal connection to an antenna 1. Implementation of the solution does not constitute a limitation on composition and logical connection of the components in the solutions according to embodiments of this application.

In some other embodiments, more electronic devices (such as a capacitor, an inductor, and a resistor) may further be configured between the radio frequency cable connector 32 and the antenna 1, and an electrical connection manner of the electronic devices is not limited to being connected in series or parallel. For example, different electronic devices may be configured between the RF pins of the MIPI device A and the C81, to implement analog signal modulation on different paths. For another example, different electronic devices may be configured between the MIPI device A and the antenna 1, to implement modulation on an antenna port resistance, and the like.

It may be understood that in subsequent embodiments according to embodiments of this application, composition and a connection relationship of logical components are merely examples. In some other embodiments, related extension may be performed on the embodiments based on the foregoing examples. Details are not described again below.

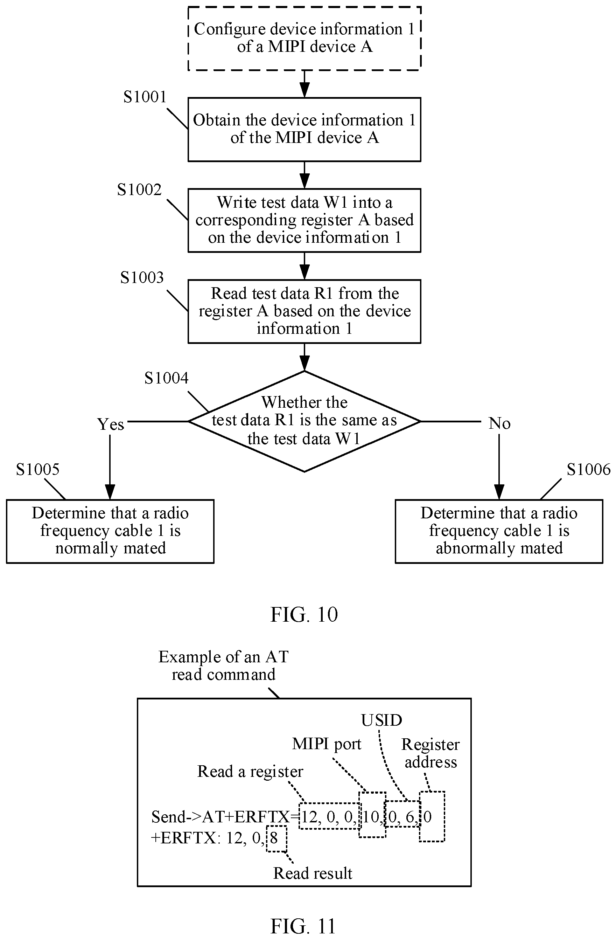

To describe the solution according to embodiments of this application more clearly, the following continues to describe, with reference to FIG. 10, the radio frequency cable mating detection solution according to embodiments of this application by using the logical connection structure shown in FIG. 8 as an example.

In some embodiments, the solution implementation shown in FIG. 10 may be configured in the baseband module. As shown in FIG. 10, the solution may include the following steps.

S1001. Obtain device information 1 of the MIPI device A.

The device information 1 may include information such as a USID corresponding to the MIPI device A, a register address (or an identifier of a register address), and a MIPI port.

For example, the USID of the MIPI device A may be configured as [0, 6], the identifier of the register address of the MIPI device A may be "0", and the MIPI port of the MIPI device A may be "10". That the USID is [0, 6] may correspond to that the USID pin of the MIPI device A is in the hardware state 1 (for example, being grounded).

In some embodiments of this application, as shown in FIG. 10, before S1001 is performed, the electronic device may further be configured with the device information 1 of the MIPI device A. For example, the device information 1 may be configured in a baseband processor of the electronic device.

In some implementations, the device information 1 may be device information in an entire machine after the machine leaves the factory.

In this example, the electronic device (for example, the baseband module in the electronic device) may obtain device information of each configured MIPI device. For example, the electronic device may obtain the device information 1 of the MIPI device A.

It should be noted that in this application, a hardware state in which the USID is [0, 6] may correspond to the hardware state in a case that the radio frequency cable 1 is normally mated. In other words, the USID of the configured MIPI device A corresponds to that the radio frequency cable 1 is normally mated.

S1002. Write the test data W1 into the corresponding register A based on the device information 1.

For example, the baseband module may determine the position of the register A corresponding to the MIPI device A based on the device information 1 of the MIPI device A.

For example, the baseband module may determine that the position of the register A is a position Lo1 based on the information that the USID is [0, 6], the register address is correspondingly "0", and the MIPI port is "10".

In step S1002, the baseband module may write the test data W1 into the register A.

For example, an example in which the test data W1 is "8" is used. The baseband module may send a command to write "8" to the position at which the register A is located.

In embodiments of this application, the test data W1 may be any value selected based on an actual situation. The test data W1 may be unrelated to the device information (such as the USID, the register address, and/or the MIPI port).

In this example, before writing the test data W1 into the register A, the electronic device (for example, the baseband module of the electronic device) may search for the register A based on the device information 1.

The circuit assembly shown in FIG. 8 is used as an example. The USID of the MIPI device A included in the device information 1 may be a value when the connection status (or the hardware state) is grounded.

When the radio frequency cable 1 is well mated, the connection status of the USID pin of the MIPI device A may be grounded. In this way, the actual USID of the MIPI device A is the same as the USID indicated by the device information 1. In this way, the baseband module can successfully find the register A corresponding to the MIPI device A based on the USID, the register address, and the MIPI port indicated by the device information 1.

Therefore, when the register A is successfully found, the baseband module can successfully write the test data W1 into the register A. When the test data W1 is successfully written into the register A, the data stored in the register A may be the test data W1.

Correspondingly, when the radio frequency cable 1 is abnormally mated, the connection status of the USID pin of the MIPI device A may be floating. In this case, the actual USID of the MIPI device A is different from the USID indicated by the device information 1. In this way, the baseband module cannot successfully find the register A corresponding to the MIPI device A based on the USID, the register address, and the MIPI port indicated by the device information 1.

In this way, the test data W1 cannot be successfully written into the register A. Correspondingly, after performance of S1002 is completed, because the test data W1 is actually not successfully written into the register A, the data stored in the register A may be null or default to "0".

In some implementations, a subsequent determining failure caused by that the written test data W1 is "0" is avoided. The test data W1 may be any value other than 0.

S1003. Read the test data R1 from the register A based on the device information 1.

With reference to the description in S1002, the baseband module may read the data from the position of the register A based on the device information 1, to obtain the test data R1.

Similar to the description in S1002, in some implementations of this example, before reading the test data R1, the baseband module may search for the register A based on the device information 1.

The USID of the MIPI device A included in the device information 1 may be a value when the connection status (or the hardware state) is grounded.

When the radio frequency cable 1 is well mated, the connection status of the USID pin of the MIPI device A may be grounded. In this way, the actual USID of the MIPI device A is the same as the USID indicated by the device information 1. It corresponds to that the register A is successfully found. Therefore, through performance of S1003, the baseband module can successfully obtain the data stored in the register A.

An example in which the test data W1 is successfully written to the register A in S1002 is used. In this case, the baseband module may obtain, through S1003, the data stored in the register A as the test data W1. In other words, the test data R1 is the same as the test data W1.

Correspondingly, when the radio frequency cable 1 is abnormally mated, the connection status of the USID pin of the MIPI device A may be floating. In this case, the actual USID of the MIPI device A is different from the USID indicated by the device information 1. The actual USID of the MIPI device A is different from the USID indicated by the device information 1. It corresponds to that the register A cannot be successfully found (that is, the searching for the register A fails). Therefore, through performance of S1003, the baseband module cannot successfully obtain the data stored in the register A. For example, the baseband module may obtain a return result of "false" or "0" through performance of S1003. In this case, the test data R1 may be "false" or "0".

In this example, the electronic device may determine, based on subsequent comparison logic, whether the test data R1 is the same as the written data W1, to determine whether the radio frequency cable 1 is normally mated. In this way, step S1003 may be performed after step S1002. For example, after performing S1002 of completing writing of the test data W1, the baseband module may search for the register A based on the device information 1. When the register A can be successfully found, the baseband module may write the test data R1 into the register A.

It should be noted that the foregoing S1002 and S1003 performed by the baseband module may be two processes independent of each other. Performance of the two processes does not affect each other.

In some embodiments, the baseband module may sequentially perform S1002 and S1003. For example, the baseband module may perform S1003 after performing S1002.

In some other embodiments, the read operation of S1003 may not depend on completion of performance of S1002. An example in which the test data W1 has been written into the register A by default is used. The baseband module may skip S1002, and directly perform S1003. In this way, the baseband module may perform subsequent step S1004 based on the obtained test data R1 and the default written test data W1.

In some embodiments of this application, the baseband module may perform a data read/write operation on the register A through an AT command.

For example, refer to FIG. 11. FIG. 11 provides an example of an AT command.

As shown in FIG. 11, the AT command may include at least 7 bits.

The first bit to the third bit are used for indicating that the AT command instructs to write data or read data.

In the example in FIG. 11, the first bit to the third bit is "12, 0, 0", which correspondingly indicates that the data is read. Correspondingly, the first bit to the third bit is "12, 0, 1", which correspondingly indicates that the data is written.

The fourth bit of the AT command indicates a MIPI port of a register on which a read/write operation needs to be performed. For example, an example in which a data read/write operation is performed on the register A of the MIPI device A is used. The fourth bit of the AT command may be configured as "10".

It should be noted that, in some other implementations, when the fourth bit of the AT command is configured as a single-digit number, the single-digit number can be used for indicating the MIPI port. For example, if the fourth bit of the AT command is configured as "3", it correspondingly indicates that the MIPI port of the register is configured as 3. In some other implementations, when the fourth bit of the AT command is configured as a two-digit number greater than 10, the units digit of the two-digit number can be used for indicating the MIPI port. For example, if the fourth bit of the AT command is configured as "15", it correspondingly indicates that the MIPI port of the register is configured as 5.

The fifth bit and the sixth bit of the AT command indicate a USID of the register on which a read/write operation needs to be performed. The USID may be determined based on the device information 1 obtained by the baseband module in S1001. In other words, the USID in the AT command may be a USID already configured for the MIPI device A. For example, the fifth bit and the sixth bit of the AT command may include "0, 6".

The seventh bit of the AT command indicates a register address of the register on which a read/write operation needs to be performed. Similar to the configuration manner of the USID, the baseband module may configure the seventh bit in the AT command as "0" based on the device information 1.

Therefore, the operations of S1002 and S1003 may be implemented based on the configuration of the AT command.

It may be understood that, when the actual USID of the MIPI device A is consistent with the configured USID, the baseband module may successfully write the test data W1 (for example, "8") to the register A through S1002. Correspondingly, the baseband module may read and obtain the test data R1 in the register A through S1003. The test data R1 may include "8".

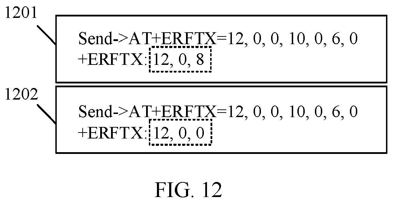

For example, refer to 1201 in FIG. 12. After the baseband module executes the AT command "send->AT+ERFTX=12,0,0,10,0,6,0", the obtained return information may include "+ERFTX:12,0,8". In other words, the read test data R1 may be "8".

When the actual USID of the MIPI device A is not consistent with the configured USID, the baseband module cannot successfully write the test data W1 (for example, "8") to the register A through S1002. An example in which a default configuration of the register A is "0" is used. Then, after processing of S1002 is completed, a value actually stored in the register A is still "0".

The baseband module cannot successfully read the value in the register A through S1003. For example, the returned read result is false or 0.

For example, refer to 1202 in FIG. 12. After the baseband module executes the AT command "send->AT+ERFTX=12,0,0,10,0,6,0", the obtained return information may include "+ERFTX:12,0,0". In other words, the read test data R1 may be "0".

It may be understood that, in this example, a change of the actual USID of the MIPI device A may be caused by abnormal mating of the radio frequency cable 1 on the path corresponding to the MIPI device A.

For example, refer to the description in FIG. 9. When the radio frequency cable 1 is normally mated, a direct current signal path may return to the ground along USID-L81-L82. In other words, when the radio frequency cable 1 is normally mated, the USID pin is set to be grounded and is in the hardware state 1, and a corresponding USID may be [0, 6].

When the radio frequency cable 1 is abnormally mated, the direct current signal path may be disconnected between L81 and L82 along USID-L81. In other words, when the radio frequency cable 1 is abnormally mated, the USID pin is set to be floating and is in the hardware state 3, and the corresponding USID is changed from [0, 6] to [0, 7].

Therefore, through reading/writing of the test data, a mating condition of the radio frequency cable 1 can be correspondingly indicated.

S1004. Determine whether the test data R1 is the same as the test data W1.

In this example, the baseband module may determine whether the test data W1 is the same as the test data R1, to determine a subsequent step.

In some embodiments, the baseband module may indicate that actual device information of the MIPI device A is the same as the configured device information when the written test data W1 is the same as the read test data R1. Therefore, an actual hardware state of the USID of the MIPI device A is the same as the hardware state in a case that the radio frequency cable 1 is normally mated. Therefore, the baseband module may jump to perform S1005.

In some other embodiments, the baseband module may indicate that actual device information of the MIPI device A is different from the configured device information when the written test data W1 is different from the read test data R1. Therefore, an actual hardware state of the USID of the MIPI device A is different from the hardware state in a case that the radio frequency cable 1 is normally mated. Therefore, the baseband module may jump to perform S1006.

S1005. Determine that the radio frequency cable 1 is normally mated.

For example, the baseband module may determine that the radio frequency cable 1 is normally mated when the actual hardware state of the USID of the MIPI device A is the same as the hardware state in a case that the radio frequency cable 1 is normally mated.

S1006. Determine that the radio frequency cable 1 is abnormally mated.

For example, the baseband module may determine that the radio frequency cable 1 is abnormally mated when the actual hardware state of the USID of the MIPI device A is different from the hardware state in a case that the radio frequency cable 1 is normally mated.

In some implementations, the electronic device may output prompt information when obtaining the indication from S1005 that the radio frequency cable 1 is normally mated or the indication from S1006 that the radio frequency cable 1 is abnormally mated.

For example, the prompt information may include prompt information of "The radio frequency cable 1 is normally mated" or "The radio frequency cable 1 is abnormally mated" displayed on a display screen of the electronic device. For another example, the prompt information may include prompt information that is displayed on a display screen through a command prompt and that indicates whether the radio frequency cable is normally mated, and the like.

Based on this, under the coupling relationship of the components shown in FIG. 8, the MIPI device A in the antenna module is connected to the radio frequency module through the radio frequency cable 1, and the electronic device can quickly and accurately determine whether the radio frequency cable 1 is well mated through the solution implementation shown in FIG. 10.

In some other embodiments of this application, the antenna module may further include an antenna path on which no MIPI device is disposed. Therefore, through the solution according to embodiments of this application, detection of a mating condition of a plurality of radio frequency cables through a MIPI device of one antenna path can also be implemented.

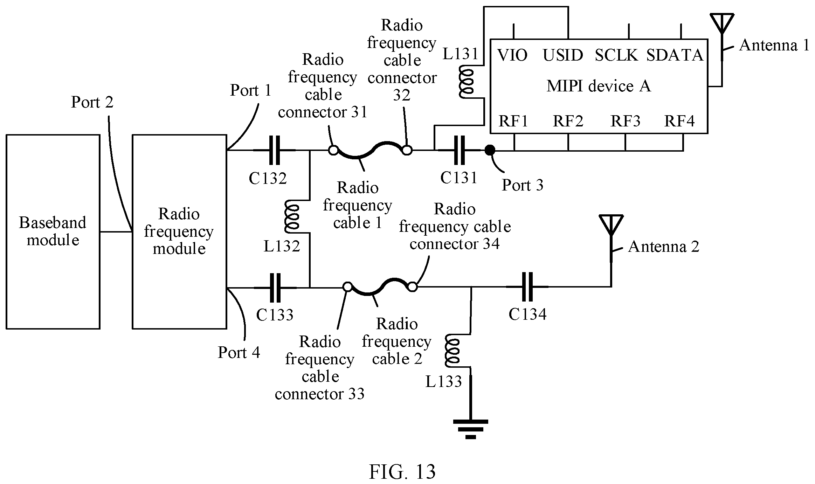

For example, refer to FIG. 13. FIG. 13 is a schematic diagram of still another circuit assembly according to an embodiment of this application.

With reference to the example in FIG. 8, in the solution shown in FIG. 13, an electronic device may also be configured with a baseband module, a radio frequency module, and an antenna module.

In the example shown in FIG. 13, the antenna module may include two antennas, for example, an antenna 1 and an antenna 2. A MIPI device A is configured on an antenna path of the antenna 1. An antenna path of the antenna 2 does not include a MIPI device.

In some implementations, at least some operating frequency bands covered by the antenna 1 and the antenna 2 may be different. In this way, the antenna 1 and the antenna 2 may respectively provide coverage capabilities of different frequency bands. For example, the antenna 1 may correspondingly cover a low frequency (for example, 700 MHz to 960 MHz), and the antenna 2 may correspondingly cover a medium-high frequency (for example, 1710 MHz to 3 GHz).

In this example, the antenna 1 and the antenna 2 may both be configured on PCB2. In some other implementations, the antenna 1 and the antenna 2 may be configured on different PCBs.

As shown in FIG. 13, the antenna 1 may implement, through a radio frequency cable 1, flowing of an analog signal (for example, a low-frequency signal) in an antenna path 1 between PCB1 and PCB2. For example, one end of the radio frequency cable 1 may be mated with a radio frequency cable connector 31 on PCB1, and the other end of the radio frequency cable 1 may be mated with a radio frequency cable connector 32 on PCB2.

The antenna 2 may implement, through a radio frequency cable 2, flowing of an analog signal (for example, a medium-high frequency signal) in a corresponding antenna path 2 between PCB1 and PCB2. For example, one end of the radio frequency cable 2 may be mated with a radio frequency cable connector 33 on PCB1, and the other end of the radio frequency cable 2 may be mated with a radio frequency cable connector 34 on PCB2.

Logical connections of the devices on the PCBs are respectively used as examples below.

With reference to description in FIG. 8, on PCB2, the antenna path 1 corresponding to the antenna 1 may include the antenna 1 and the MIPI device A. The antenna 1 may be coupled to the MIPI device A. Each radio frequency pin of the MIPI device A is directly or indirectly (for example, through a matching device) coupled to a port 3. The port 3 is coupled to the radio frequency cable connector 32 through at least one capacitor 131 connected in series.

In addition, a USID pin of the MIPI device A is coupled to the radio frequency cable connector 32 through at least one inductor L131.

On PCB2, the antenna path 2 corresponding to the antenna 2 may include the antenna 2. The antenna 2 may be directly or indirectly (for example, through the matching device) coupled to the radio frequency cable connector 34. In this example, at least one capacitor C134 connected in series may be disposed between the antenna 2 and the radio frequency cable connector 34. At least one inductor L133 connected in parallel may further be disposed between the antenna 2 and the radio frequency cable connector 34. In some implementations, the inductors L133 connected in parallel may be disposed between the capacitor C134 and the radio frequency cable connector 34.

The components such as the baseband module and the radio frequency module may be configured on PCB1. The baseband module and the radio frequency module may have a coupling relationship.

In this example, the antenna 1 and the antenna 2 may separately cover different frequency bands. For example, as in the foregoing descriptions, the antenna 1 may be configured to cover a low-frequency band, and the antenna 2 may be configured to cover a medium-high-frequency band. Correspondingly, in the radio frequency module, corresponding radio frequency processing links may be respectively configured for the low frequency and the medium-high frequency. In this way, the radio frequency module may include a port 1 corresponding to the low-frequency radio frequency processing link and a port 4 corresponding to the medium-high-frequency radio frequency processing link.

As shown in FIG. 13, in this example, on PCB1, the radio frequency module may be coupled to a corresponding antenna path through the port 1 and the port 4 respectively.

For example, the port 1 of the radio frequency module may be coupled to the radio frequency cable connector 31. At least one capacitor C132 may be connected in series between the port 1 and the radio frequency cable connector 31.

The port 4 of the radio frequency module may be coupled to the radio frequency cable connector 33. At least one capacitor C133 may be connected in series between the port 4 and the radio frequency cable connector 33.

In addition, the radio frequency cable connector 31 may be coupled to the radio frequency cable connector 33 through at least one inductor L133.

In this way, through the configuration of the plurality of inductors and capacitors shown in FIG. 13, based on different impedance characteristics of the inductor and the capacitor to the direct current signal and the alternating current signal, the electronic device can determine, through the MIPI device A, whether the radio frequency cable 1 and the radio frequency cable 1 are normally mated at the same time.

In an example, the logical connection shown in FIG. 13 is used as an example.

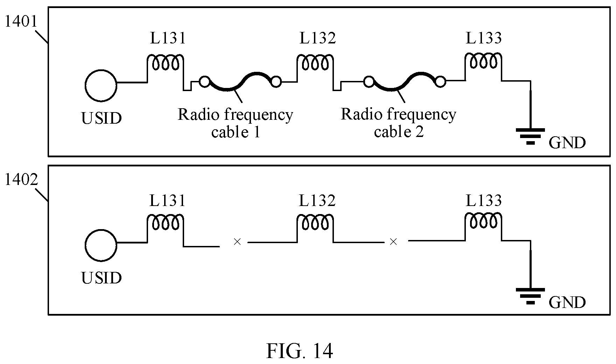

A case that the radio frequency cable 1 and the radio frequency cable 2 are normally mated at the same time is shown in 1401 in FIG. 14. The USID pin of the MIPI device A may return to the ground through L131, the radio frequency cable 1, L132, the radio frequency cable 2, and L133.

In this way, that the radio frequency cable 1 and the radio frequency cable 2 are normally mated at the same time may correspond to that the USID pin of the MIPI device A is in the hardware state 1 (that is, being grounded).

In this example, the electronic device may configure the hardware state 1 in the device information 1 of the MIPI device A. In this way, with reference to S1001 to S1003 in FIG. 10, the baseband module may obtain the test data W1 and the test data R1 by reading/writing the data. The baseband module may determine, based on that the test data W1 is the same as the test data R1, that the radio frequency cable 1 and the radio frequency cable 2 are normally mated at the same time.

In some other cases, when the radio frequency cable 1 and/or the radio frequency cable 2 is abnormally mated, the USID pin of the MIPI device A may be in the hardware state 3 (for example, being disconnected). For example, in 1402 in FIG. 14, an example in which the radio frequency cable 1 and the radio frequency cable 2 are abnormally mated is used.

As shown in 1402 in FIG. 14, the USID pin of the MIPI device A may be in a disconnected state after passing through L131.

In this way, that the radio frequency cable 1 and the radio frequency cable 2 are abnormally mated may correspond to that the USID pin of the MIPI device A is in the hardware state 1 (that is, being grounded).

It may be understood that in another case, for example, in a case that the radio frequency cable 1 or the radio frequency cable 2 is abnormally mated, the USID pin of the MIPI device A may also be in the disconnected state.

In this example, the electronic device may configure the hardware state 1 in the device information 1 of the MIPI device A. In this way, with reference to S1001 to S1003 in FIG. 10, the baseband module may obtain the test data W1 and the test data R1 by reading/writing the data. The baseband module may determine, based on that the test data W1 is different from the test data R1, that at least one of the radio frequency cable 1 and the radio frequency cable 2 is abnormally mated.

It may be understood that, in this example, capacitors connected in series are further configured on an analog link. Based on a characteristic of passing alternating current and blocking direct current by the capacitor, when transmission of an analog signal (that is, a radio frequency signal) is not affected, after the USID pin of the MIPI device A sends a direct current signal, the direct current signal may flow in a manner such as 1401 or 1402 shown in FIG. 14.

In this way, a mating state of two or more radio frequency cables may be detected through one MIPI device.

It may be understood that FIG. 8 to FIG. 14 respectively provide the solution for detecting the mating state of the radio frequency cable in two different scenarios. The solution may be further extended to other antenna configuration scenarios.

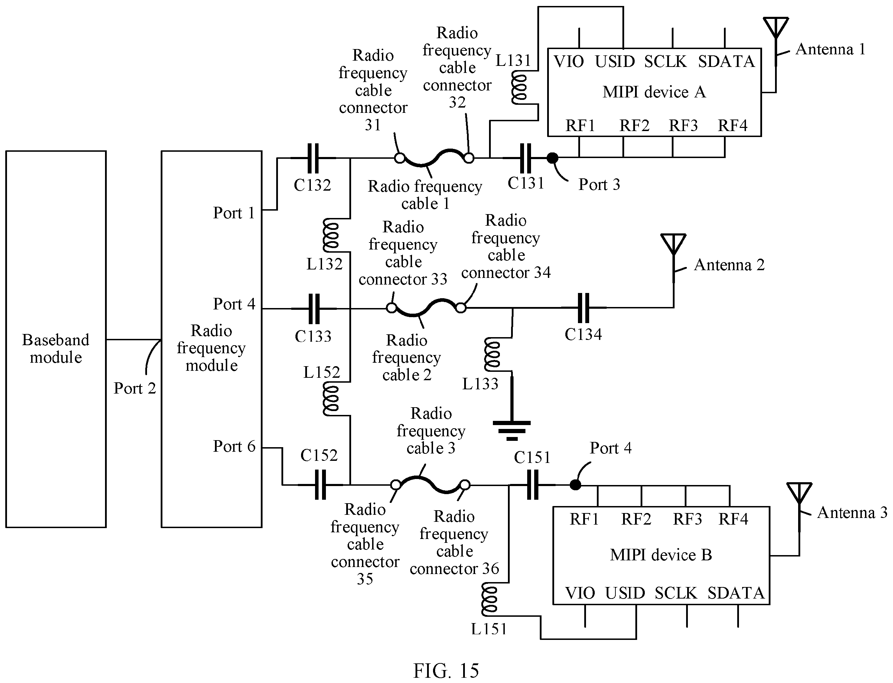

For example, refer to FIG. 15. FIG. 15 is a schematic diagram of still another circuit assembly according to an embodiment of this application. In this example, an antenna module in an electronic device may include more antennas (for example, an antenna 1, an antenna 2, and an antenna 3). A MIPI device A may be configured on an antenna path 1 of the antenna 1, no MIPI device is configured on an antenna path 2 of the antenna 2, and a MIPI device (for example, a MIPI device B) may also be configured on an antenna path 3 of the antenna 3.

The antenna path 1, the antenna path 2, and the antenna path 3 are respectively coupled to a radio frequency module through a radio frequency cable.

For example, an example in which the antenna 1 corresponds to an operating link is used.

In the antenna path 1, the antenna 1 is coupled to the MIPI device A (for example, an output end of the MIPI device A), and a radio frequency port (for example, a port 3) of the MIPI device A is coupled to a radio frequency cable connector 32.

A radio frequency processing link at a front end of a port 1 of the radio frequency module may have a radio frequency processing capability of a frequency band corresponding to an operating frequency band of the antenna 1. In this way, the radio frequency module may be coupled to a radio frequency cable connector 31 through the port 1.

A communication connection is implemented through a radio frequency cable 1 before the radio frequency cable connector 31 and the radio frequency cable connector 32.

An example in which the antenna 2 corresponds to an operating link is used.

In the antenna path 2, the antenna 2 is coupled to a radio frequency cable connector 34.

A radio frequency processing link at a front end of a port 4 of the radio frequency module may have a radio frequency processing capability of a frequency band corresponding to an operating frequency band of the antenna 2. In this way, the radio frequency module may be coupled to a radio frequency cable connector 33 through the port 4.

A communication connection is implemented through a radio frequency cable 2 before the radio frequency cable connector 33 and the radio frequency cable connector 34.

An example in which the antenna 3 corresponds to an operating link is used.

In the antenna path 3, the antenna 3 is coupled to the MIPI device B (for example, an output end of the MIPI device B), and a radio frequency port (for example, the port 4) of the MIPI device B is coupled to a radio frequency cable connector 36. In a specific implementation, the port 4 may be coupled to each radio frequency pin of the MIPI device B, so that when any one of the RF ports is turned on, a radio frequency signal may be transmitted to the antenna 3 through the port 4 and the turned-on radio frequency pin.

A radio frequency processing link at a front end of a port 6 of the radio frequency module may have a radio frequency processing capability of a frequency band corresponding to an operating frequency band of the antenna 3. In this way, the radio frequency module may be coupled to a radio frequency cable connector 35 through the port 6.

A communication connection is implemented through a radio frequency cable 3 before the radio frequency cable connector 35 and the radio frequency cable connector 36.

With reference to the descriptions of FIG. 8 to FIG. 14, in the example shown in FIG. 15, capacitors connected in series and inductors connected in parallel may also be correspondingly configured on the analog links corresponding to the antennas, to determine, by reading/writing data of the MIPI device A and the MIPI device B, whether the radio frequency cable 1, the radio frequency cable 2, and the radio frequency cable 3 are abnormally mated.

For example, as shown in FIG. 15, on the analog link 1 of the antenna 1, at least one capacitor C131 may be connected in series between the port 3 and the radio frequency cable connector 32, to conduct a radio frequency signal and stop a direct current signal (for example, a signal sent by the USID pin). At least one inductor L131 may be connected in parallel between the USID pin of the MIPI device A and the radio frequency cable connector 32, to facilitate conduction of the direct current signal. In some implementations, one end, different from the end connected to the USID pin, of the at least one inductor L131 may be coupled between the capacitor C131 and the radio frequency cable connector 32.

Correspondingly, at least one capacitor C132 may be connected in series between the port 1 of the radio frequency module and the radio frequency cable connector 31, to conduct a radio frequency signal and stop a direct current signal.

In addition, at least one inductor L132 may be disposed between the radio frequency cable connector 31 and the radio frequency cable connector 33, to facilitate conduction of the direct current signal.

On the analog link 2 of the antenna 2, at least one capacitor C134 may be connected in series between the antenna 2 and the radio frequency cable connector 34, to conduct a radio frequency signal and stop a direct current signal. At least one inductor L131 may further be connected in parallel between the antenna 2 and the radio frequency cable connector 32, to facilitate conduction of the direct current signal. In some implementations, the at least one inductor L131 may be configured in parallel between the capacitor C134 and the radio frequency cable connector 34.

Correspondingly, at least one capacitor C133 may be connected in series between the port 4 of the radio frequency module and the radio frequency cable connector 33, to conduct a radio frequency signal and stop a direct current signal.

In addition, at least one inductor L152 may be disposed between the radio frequency cable connector 33 and the radio frequency cable connector 35, to facilitate conduction of the direct current signal.

On the analog link 3 of the antenna 3, at least one capacitor C151 may be connected in series between the port 4 and the radio frequency cable connector 36, to conduct a radio frequency signal and stop a direct current signal. At least one inductor L151 may be connected in parallel between the USID pin of the MIPI device B and the radio frequency cable connector 36, to facilitate conduction of the direct current signal. In some implementations, one end, different from the end connected to the USID pin, of the at least one inductor L151 may be coupled between the capacitor C151 and the radio frequency cable connector 36.

Correspondingly, at least one capacitor C152 may be connected in series between the port 6 of the radio frequency module and the radio frequency cable connector 35, to conduct a radio frequency signal and stop a direct current signal.

Therefore, based on the logical connection shown in FIG. 15, the electronic device (for example, the baseband module of the electronic device) may determine a mating state of each radio frequency cable by separately reading/writing the data of the MIPI device A and the MIPI device B.

For the data read/write process of the baseband module targeting the MIPI device A or the MIPI device B, refer to S1001 to S1003 in FIG. 10. Details are not described again.

It may be understood that the USIDs included in the device information of the MIPI device A and the MIPI device B that are already configured in the electronic device may respectively correspond to USIDs corresponding to hardware states of the USID pins of the radio frequency cable 1, the radio frequency cable 2, and the radio frequency cable 3 that are respectively in a normally mated state.

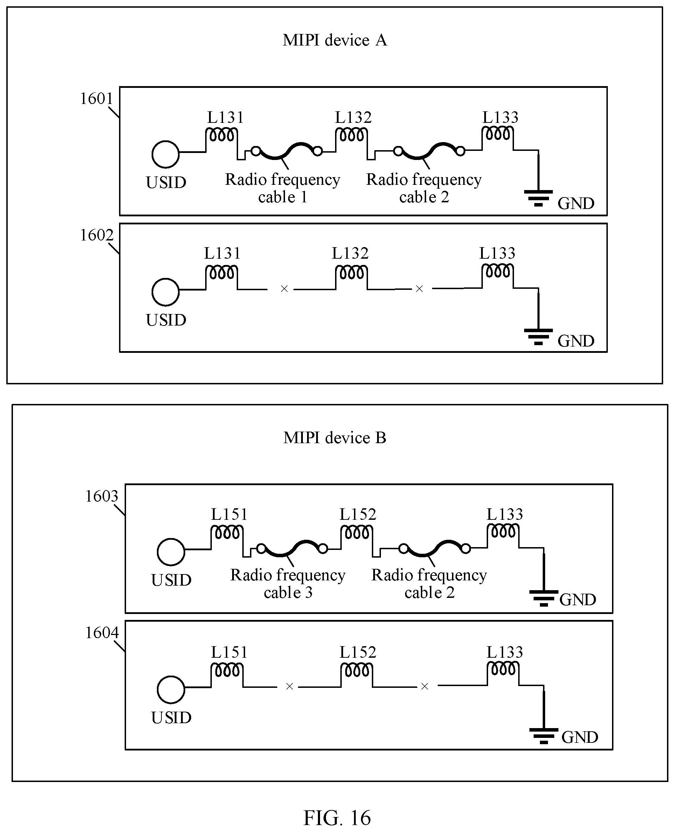

For example, with reference to FIG. 15, refer to FIG. 16.

For the MIPI device A, when the radio frequency cable 1 and the radio frequency cable 2 are both normally mated, as shown in 1601, the direct current signal sent by the USID pin may return to the ground through L131, the radio frequency cable 1, L132, the radio frequency cable 2, and L133. In other words, when the hardware state of the USID pin of the MIPI device A is grounded (that is, the hardware state 1), it indicates that the radio frequency cable 1 and the radio frequency cable 2 are both normally mated.

With reference to FIG. 10, in a process of reading/writing the data of the register A, when the read data is the same as the written data, the hardware state of the USID pin of the MIPI device A is the same as the configured hardware state, for example, the hardware state 1.

Correspondingly, as shown in 1602, when the hardware state of the USID pin of the MIPI device A is floating (that is, the hardware state 3), it indicates that at least one of the radio frequency cable 1 and the radio frequency cable 2 is abnormally mated.

With reference to FIG. 10, in the process of reading/writing the data of the register A, when the read data is different from the written data, the hardware state of the USID pin of the MIPI device A is different from the configured hardware state, for example, the hardware state 3.

For the MIPI device B, when the radio frequency cable 3 and the radio frequency cable 2 are both normally mated, as shown in 1603, the direct current signal sent by the USID pin may return to the ground through L151, the radio frequency cable 3, L152, the radio frequency cable 2, and L133. In other words, when the hardware state of the USID pin of the MIPI device B is grounded (that is, the hardware state 1), it indicates that the radio frequency cable 3 and the radio frequency cable 2 are both normally mated.

With reference to FIG. 10, in a process of reading/writing the data of the register B, when the read data is the same as the written data, the hardware state of the USID pin of the MIPI device B is the same as the configured hardware state, for example, the hardware state 1.

Correspondingly, when the hardware state of the USID pin of the MIPI device B is floating (that is, the hardware state 3), it indicates that at least one of the radio frequency cable 3 and the radio frequency cable 2 is abnormally mated.

With reference to FIG. 10, in the process of reading/writing the data of the register B, when the read data is different from the written data, the hardware state of the USID pin of the MIPI device B is different from the configured hardware state, for example, the hardware state 3.

Based on this, the following Table 2 provides correspondence between different USID hardware states and mating states of radio frequency cables.

**Table 2**

| USID-A | USID-B | Radio frequency cable 1 | Radio frequency cable 2 | Radio frequency cable 3 |
|---|---|---|---|---|
| 3 | 3 | 1 | 0 | 0 |
| | | 0 | 1 | 0 |
| | | 0 | 0 | 1 |
| | | 0 | 0 | 0 |
| 1 | 3 | 1 | 1 | 0 |
| 1 | 1 | 1 | 1 | 1 |
| 3 | 1 | 0 | 1 | 1 |

In the example in Table 2, the USID-A corresponds to the hardware state of the USID pin of the MIPI device A. For example, if the USID-A is 3, it indicates that the USID pin of the MIPI device A is in the hardware state 3 (that is, being floating). For another example, if the USID-A is 1, it indicates that the USID pin of the MIPI device A is in the hardware state 1 (that is, being grounded). In addition, a value of the radio frequency cable is "1", which indicates that the radio frequency cable is normally mated; and a value of the radio frequency cable is "0", which indicates that the radio frequency cable is abnormally mated.

As shown in Table 2, the baseband module may determine, when both the USID-A and the USID-B are 3, that is, after reading/writing the data of the two MIPI devices, the read data is different from the written data, that the mating states of the radio frequency cables may be any one of the following.

The radio frequency cable 1 is normally mated, the radio frequency cable 2 is abnormally mated, and the radio frequency cable 3 is abnormally mated.

The radio frequency cable 1 is abnormally mated, the radio frequency cable 2 is normally mated, and the radio frequency cable 3 is abnormally mated.

The radio frequency cable 1 is abnormally mated, the radio frequency cable 2 is abnormally mated, and the radio frequency cable 3 is normally mated.

When the USID-A is 1 and the USID-B is 3, that is, after reading/writing the data of the two MIPI devices, the read data and the written data of the MIPI device A are the same, and the read data and the written data of the MIPI device B are different, that the baseband module may determine the mating states of the radio frequency cables may be as follows. The radio frequency cable 1 is normally mated, the radio frequency cable 2 is normally mated, and the radio frequency cable 3 is abnormally mated.

When the USID-A is 1 and the USID-B is 1, that is, after reading/writing the data of the two MIPI devices, the read data and the written data of the MIPI device A are the same, and the read data and the written data of the MIPI device B are also the same, that the baseband module may determine the mating states of the radio frequency cables may be as follows. The radio frequency cable 1 is normally mated, the radio frequency cable 2 is normally mated, and the radio frequency cable 3 is normally mated.

When the USID-A is 3 and the USID-B is 1, that is, after reading/writing the data of the two MIPI devices, the read data and the written data of the MIPI device A are different, and the read data and the written data of the MIPI device B are the same, that the baseband module may determine the mating states of the radio frequency cables may be as follows. The radio frequency cable 1 is abnormally mated, the radio frequency cable 2 is normally mated, and the radio frequency cable 3 is normally mated.

In this way, based on the logical connection shown in FIG. 15, the electronic device may determine the mating conditions of the radio frequency cables by reading/writing the data of the MIPI device A and the MIPI device B.

In some implementations, similar to the example in FIG. 10, the electronic device may generate prompt information after determining the mating conditions of the radio frequency cables. It is convenient to record and prompt a current mating condition of each radio frequency cable.

It may be understood that, in the foregoing embodiments, three scenarios to which embodiments of this application can be applied are respectively described by using examples.

A person skilled in the art may understand that the solutions according to embodiments of this application may also be applied to other scenarios.

For example, when the antenna module includes at least one MIPI device, a USID pin of the MIPI device may be configured to be coupled, through the inductor, to a radio frequency cable of an analog link on which the MIPI device is located, and be grounded directly or indirectly, through the inductor, at the other end of the radio frequency cable. In this case, when the radio frequency cable is normally mated or abnormally mated, the hardware state of the USID pin correspondingly changes. Further, the baseband module may determine, by reading/writing data of a register of the MIPI device, a mating condition of at least one radio frequency cable between the USID pin and a ground point.

Therefore, the mating condition of the radio frequency cable can be accurately detected without occupying a communication port (such as a GPIO port) inside the electronic device by using only a small quantity of wires and device configurations.

In comparison, in an existing solution implementation, to accurately detect the mating state of the radio frequency cable, at least one GPIO port needs to be occupied to perform related data transmission.

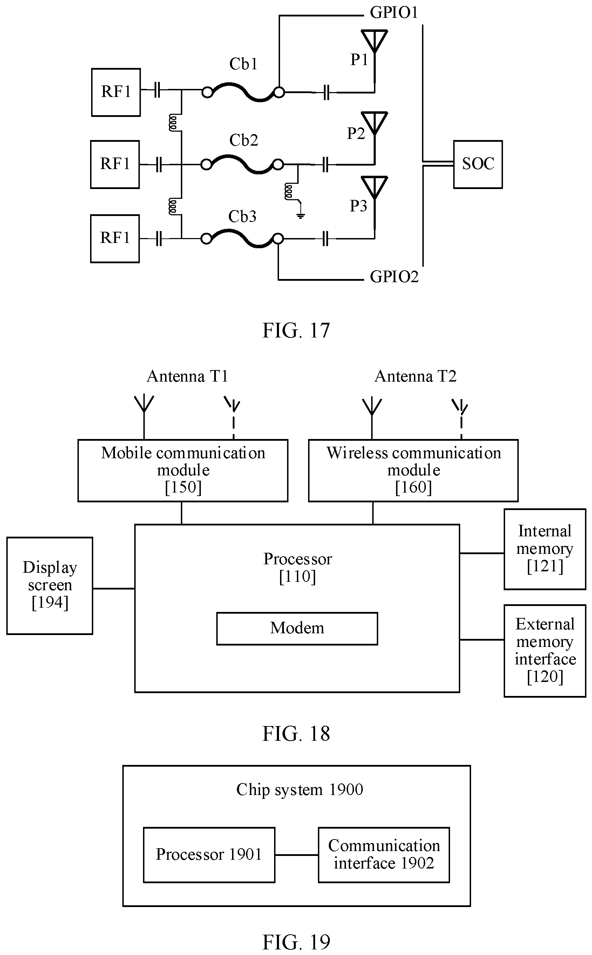

For example, refer to FIG. 17. FIG. 17 is an example of logical connection of a radio frequency cable mating state detection solution based on a GPIO port.

In the example shown in FIG. 17, an electronic device may be configured with three antennas, for example, P1, P2, and P3. The three antennas may be respectively coupled to corresponding radio frequency ports through radio frequency cables. For example, P1 is coupled to RF1 through Cable 1, P2 is coupled to RF2 through Cable 2, and P3 is coupled to RF3 through Cable 3.

On an analog path (for example, a path from an antenna port to the RF port) of each antenna, components such as capacitors and inductors that are connected in series may be configured.

In the solution example in FIG. 17, an independent GPIO port and wire (for example, GPIO1 and GPIO2) need to be configured on one end of each of Cb1 and Cb3. The GPIO wire may introduce a signal to an SOC for processing and identification.

In this way, a mating state of Cb1 and Cb3 may be transferred to the SOC through the GPIO wire. However, because the GPIO ports need to be separately configured, the already limited GPIO ports in the electronic device are occupied, thereby affecting normal configuration of other GPIO devices. In addition, because the GPIO wires need to be separately configured, the GPIO wire further needs to be connected to the SOC, so that layout on PCB1, PCB2, and a data bus is also significantly affected.

In comparison, in the solution implementations according to embodiments of this application, based on a change condition of the USID of the MIPI device and a data reading/writing capability of the baseband module to the register of the MIPI device, the mating state of the radio frequency cable is accurately detected. The GPIO port resources do not need to be occupied, and the PCB or the data bus does not need to be significantly occupied. Therefore, according to the solution implementations provided in embodiments of this application, detection of the mating state of the radio frequency cable can be better implemented.

It should be noted that the foregoing solutions provided in embodiments of this application may be applied to a process of detecting an electronic device (such as a mobile phone) in a production line before the electronic device leaves the factory. In addition, the foregoing solutions may be applied to a process in which a user uses an electronic device, so that the electronic device can automatically detect whether a radio frequency cable is well mated.

For example, the electronic device may trigger the cable detection solution shown in FIG. 10 according to a preset policy. The electronic device may further store a detection result locally or upload the detection result to a cloud server. In this way, when a wireless communication fault occurs in the electronic device, a development engineer or a maintenance engineer can quickly determine, based on the detection result, whether the problem is caused by that the radio frequency cable is not well mated.

In the descriptions of the foregoing solutions, names of the components and ports are merely examples, and do not constitute a limitation on the solutions according to embodiments of this application. In some other embodiments, names of the components and ports may be different from the foregoing descriptions.

For example, the MIPI device A may also be referred to as a first MIPI device. The antenna 1 may also be referred to as a first antenna, and the antenna 2 may also be referred to as a second antenna. The radio frequency cable 1 may also be referred to as a first radio frequency cable, and the radio frequency cable 2 may also be referred to as a second radio frequency cable. The register A of the MIPI device A may also be referred to as a first register.

In addition, the capacitor C82 may also be referred to as a first capacitor. The capacitor C81 may also be referred to as a second capacitor. The capacitor C133 may also be referred to as a third capacitor. The capacitor C134 may also be referred to as a fourth capacitor.

The inductor L81 may also be referred to as a first inductor. The inductor L82 may also be referred to as a second inductor. The inductor L132 may also be referred to as a third inductor. The inductor L133 may also be referred to as a fourth inductor.

Names of the ports may be different from the foregoing descriptions.

For example, the port 1 of the radio frequency module may be referred to as a first end of the radio frequency module. The port 2 of the radio frequency module may also be referred to as a second end of the radio frequency module. The port 4 of the radio frequency module may also be referred to as a third end of the radio frequency module.

The signal port corresponding to the radio frequency cable connector 31 of the radio frequency cable 1 may also be referred to as a first end of the first radio frequency cable. The signal port corresponding to the radio frequency cable connector 32 of the radio frequency cable 1 may also be referred to as a second end of the first radio frequency cable. The signal port corresponding to the radio frequency cable connector 33 of the radio frequency cable 2 may also be referred to as a first end of the second radio frequency cable. The signal port corresponding to the radio frequency cable connector 34 of the radio frequency cable 2 may also be referred to as a second end of the second radio frequency cable.

The port 3 of the MIPI device A may also be referred to as a first end of the first MIPI device. The port of the MIPI device A that is connected to the antenna 1 may also be referred to as a second end of the first MIPI device. The port of the MIPI device A that is connected to the register A may also be referred to as a third end of the first MIPI device.

Correspondingly, the port of the first register to which the baseband module is connected may also be referred to as a first end of the first register. The port of the first register to which the MIPI device A is connected may also be referred to as a second end of the first register.

The solutions according to embodiments of this application may be applied to an electronic device. The electronic device may be configured with a baseband module, a radio frequency module, and an antenna module. The antenna module may include at least one MIPI device.

In addition, in the foregoing examples, an example in which the radio frequency module and the antenna module are configured on different PCBs, and therefore, the radio frequency cable is configured to implement inter-board signal transmission is used. In some other cases, even if two components (for example, the radio frequency module and the antenna module) are configured on a same PCB, data transmission may be performed through the radio frequency cable. Therefore, the solutions according to embodiments of this application may be applied to detection of whether the radio frequency cable is normally mated in this scenario. In other words, in embodiments of this application, a quantity of the configured PCBs in the electronic device and a bearing relationship between the components and the PCBs are not limited.

In different implementations, the electronic device may include at least one of a mobile phone, a foldable electronic device, a tablet computer, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a wearable device, an in-vehicle device, a smart household device, or a smart city device.

In an example, FIG. 18 is a schematic diagram of composition of an electronic device.

As shown in FIG. 18, the electronic device may include a processor 110, an external memory interface 120, an internal memory 121, a display screen 194, an antenna T1, an antenna T2, a mobile communication module 150, a wireless communication module 160, and the like.

In some other embodiments, the electronic device may further include a universal serial bus (universal serial bus, USB) connector, a charging management module, a power management module, a battery, an audio module, a speaker, a receiver, a microphone, a headset jack, a sensor module, a button, a motor, an indicator, a camera module, a subscriber identification module (subscriber identification module, SIM) card interface, and the like. The sensor module may include a pressure sensor, a gyro sensor, a barometric pressure sensor, a magnetic sensor, an acceleration sensor, a distance sensor, an optical proximity sensor, a fingerprint sensor, a temperature sensor, a touch sensor, an ambient light sensor, a bone conduction sensor, and the like.

The processor may include one or more processing units. For example, the processor may include an application processor (application processor, AP), a modem processor (Modem), a graphics processing unit (graphics processing unit, GPU), an image signal processor (image signal processor, ISP), a controller, a video codec, a digital signal processor (digital signal processor, DSP), a baseband processor (baseband processor, BP or BBP), a neural-network processing unit (neural-network processing unit, NPU), and/or the like. Different processing units may be independent devices, or may be integrated in one or more processors. In some implementations, the baseband processor and the modem processor may be integrated into one component, for example, collectively referred to as the Modem. The Modem may correspond to the baseband module in the foregoing embodiments.

The processor can generate an operation control signal based on instruction operation code and a timing signal, to complete control of fetching instructions and executing instructions.

A memory may be further disposed in the processor, and may be configured to store instructions and data. In some embodiments, the memory in the processor may be a cache memory. The memory may store instructions or data that are used or used frequently by the processor. If the processor needs to use the instructions or data, the processor may directly invoke the instructions or data from the memory. This avoids repeated access and reduces waiting time of the processor, thereby improving system efficiency.

For example, in some implementations, the register module may be configured in the memory in the Modem.

In some other implementations, the register module may be configured in the internal memory 121, or stored in an external storage device through the external memory interface 120.

A wireless communication function of the electronic device may be implemented through the antenna T1, the antenna T2, the mobile communication module, the wireless communication module, the modem processor, the baseband processor, and the like.

Correspondingly, in the foregoing embodiments, the antenna T1 and the antenna T2 may be used as a set of different functional antennas. The antenna 1, the antenna 2, and the antenna 3 may be included in the antenna T1 and/or the antenna T2.

The antenna T1 and the antenna T2 are configured to transmit and receive an electromagnetic wave signal. Each antenna in the electronic device may be configured to cover one or more communication bands. Different antennas may also be multiplexed to improve utilization of the antenna. For example, the antenna T1 may be multiplexed into a diversity antenna of a wireless local area network. In some other embodiments, the antenna may be used in combination with a tuning switch. For example, the tuning switch may include the MIPI device.

The mobile communication module may provide a solution applied to the electronic device for wireless communication such as 2G, 3G, 4G, or 5G. The mobile communication module may include at least one filter, a switch, a power amplifier, a low noise amplifier (low noise amplifier, LNA), and the like. The mobile communication module may receive an electromagnetic wave through the antenna T1, perform processing such as filtering or amplification on the received electromagnetic wave, and transmit a processed electromagnetic wave to the modem processor for demodulation. The mobile communication module may further amplify a signal modulated by the modem processor, and convert an amplified signal into an electromagnetic wave for radiation through the antenna T1. In some embodiments, at least some functional modules in the mobile communication module may be disposed in the processor. In some embodiments, at least some functional modules in the mobile communication module may be disposed in a same device as at least some modules in the processor.

The modem processor may include a modulator and a demodulator. The modulator is configured to module a to-be-sent low-frequency baseband signal into a medium-high-frequency signal. The demodulator is configured to demodulate a received electromagnetic wave signal into a low-frequency baseband signal. Next, the demodulator transmits the demodulated low-frequency baseband signal to the baseband processor for processing. The low-frequency baseband signal is processed by the baseband processor and then transferred to the application processor. The application processor outputs a sound signal through an audio device (which is not limited to a speaker, a receiver, or the like), or displays an image or a video through a display screen. In some embodiments, the modem processor may be an independent device. In some other embodiments, the modem processor may be independent of the processor, and the modem processor and the mobile communication module or another functional module may be disposed in a same device.

The wireless communication module may provide a solution for wireless communication that is applied to the electronic device and that includes a wireless local area network (wireless local area networks, WLAN) (such as a wireless fidelity (wireless fidelity, Wi-Fi) network), Bluetooth (bluetooth, BT), Bluetooth low energy (bluetooth low energy, BLE), ultra wide band (ultra wide band, UWB), a global navigation satellite system (global navigation satellite system, GNSS), frequency modulation (frequency modulation, FM), near field communication (near field communication, NFC), an infrared (infrared, IR) technology, and the like. The wireless communication module may be one or more devices into which at least one communication processing module is integrated. The wireless communication module receives an electromagnetic wave through the antenna T2, performs frequency modulation and filtering processing on an electromagnetic wave signal, and sends a processed signal to the processor. The wireless communication module may further receive a to-be-sent signal from the processor, perform frequency modulation and amplification on the to-be-sent signal, and convert the to-be-sent signal into an electromagnetic wave through the antenna T2 for radiation.

In some embodiments, in the electronic device, the antenna T1 is coupled to the mobile communication module, and the antenna T2 is coupled to the wireless communication module, so that the electronic device can communicate with a network and another electronic device according to a wireless communication technology. The wireless communication technology may include a global system for mobile communications (global system for mobile communications, GSM) technology, a general packet radio service (general packet radio service, GPRS) technology, a code division multiple access (code division multiple access, CDMA) technology, a wideband code division multiple access (wideband code division multiple access, WCDMA) technology, a time-division code division multiple access (time-division code division multiple access, TD-SCDMA) technology, a long term evolution (long term evolution, LTE) technology, a BT technology, a GNSS technology, a WLAN technology, an NFC technology, an FM technology, an IR technology, and/or the like. The GNSS may include a global positioning system (global positioning system, GPS), a global navigation satellite system (global navigation satellite system, GLONASS), a BeiDou navigation satellite system (beidou navigation satellite system, BDS), a quasi-zenith satellite system (quasi-zenith satellite system, QZSS), and/or a satellite based augmentation system (satellite based augmentation systems, SBAS).

It may be understood that, a schematic interface connection relationship between the modules in embodiments of this application is merely an example for description, and constitutes no limitation on the structure of the electronic device. In some other embodiments of this application, the electronic device may alternatively use an interface connection manner different from that in the foregoing embodiment, or use a combination of a plurality of interface connection manners.

It should be noted that the structure shown in embodiments of this application does not constitute a specific limitation on the electronic device. In some other embodiments of this application, the electronic device may include more or fewer components than those shown in the figure, some components may be combined, some components may be split, or a different component arrangement may be used. Components shown in the figure may be implemented by using hardware, software, or a combination of software and hardware.

It may be understood that, to implement the foregoing functions, the electronic device according to embodiments of this application includes a corresponding hardware structure and/or software module for performing the functions. A person skilled in the art easily realizes that embodiments of this application may be implemented in hardware or a combination of hardware and computer software with reference to the units and algorithm steps in the examples described in embodiments disclosed in this specification. Whether a function is executed by hardware or computer software driving hardware depends on specific applications and design constraint conditions of the technical solutions. A person skilled in the art may use different methods to implement the described functions for each specific application, but it should not be considered that the implementation goes beyond the scope of embodiments of this application.

In embodiments of this application, division on functional modules of the electronic device may be performed based on the method examples. For example, the functional modules may be correspondingly divided for each function, or two or more functions may be integrated in one processing module. The integrated module may be implemented in a form of hardware, or may be implemented in a form of a software functional module. It should be noted that, module division in embodiments of this application is an example, and is merely a logical function division. During actual implementation, another division manner may be used.

FIG. 19 is a schematic diagram of composition of a chip system 1900. The chip system 1900 may include: a processor 1901 and a communication interface 1902, which are configured to support a related device to implement the functions involved in the foregoing embodiments. In a possible design, the chip system further includes a memory, configured to store program instructions and data necessary for an electronic device. The chip system may include chips, or may include a chip and another discrete device. It should be noted that in some implementations of this application, the communication interface 1902 may also be referred to as an interface circuit. In some implementations, the chip system 1900 may be configured with processing logic related to FIG. 10 or another embodiment, so that the electronic device (for example, a baseband module of the electronic device) performs rapid detection of radio frequency cable mating according to the solutions provided in embodiments of this application.

It should be noted that all related content of the steps in the foregoing method embodiments may be cited in function descriptions of corresponding functional modules. Details are not described herein again.

All or a part of the functions, actions, operations, or steps in the foregoing embodiments may be implemented by using software, hardware, firmware, or any combination thereof. When a software program is used to implement embodiments, all or a part of embodiments may be implemented in a form of a computer program product. The computer program product includes one or a plurality of computer instructions. When the computer program instructions are loaded and executed on a computer, all or a part of the procedures or functions according to embodiments of this application are generated. The computer can be a general-purpose computer, a dedicated computer, a computer network, or another programmable apparatus. The computer instructions may be stored in a computer-readable storage medium, or may be transmitted from a computer-readable storage medium to another computer-readable storage medium. For example, the computer instructions may be transmitted from a website, a computer, a server, or a data center to another website, computer, server, or data center in a wired manner (for example, through a coaxial cable, an optical fiber, or a digital subscriber line (digital subscriber line, DSL)) or a wireless manner (for example, in an infrared, radio, or microwave manner). The computer-readable storage medium may be any usable medium accessible by a computer, or a data storage device, such as a server or a data center, integrating one or more usable media. The usable medium may be a magnetic medium (for example, a floppy disk, a hard disk drive, or a magnetic tape), an optical medium (for example, a DVD), a semiconductor medium (for example, a solid state drive (solid state disk, SSD)), or the like.

Although this application is described with reference to specific features and embodiments, it is clear that various modifications and combinations may be made to this application without departing from the spirit and scope of this application. Correspondingly, this specification and the accompanying drawings are merely example descriptions of this application defined by the appended claims, and are considered as having covered any of and all of modifications, variations, combinations, or equivalents within the scope of this application. It is clear that a person skilled in the art can make various modifications and variations to this application without departing from the spirit and scope of this application. In this case, if the modifications and the variations made to this application fall within the scope of the claims of this application and equivalent technologies thereof, this application is intended to include these modifications and variations.

## Claims

1. A circuit assembly, comprising: a radio frequency module, an antenna module, and a first radio frequency cable, wherein
the antenna module comprises at least one MIPI device and at least one antenna; the at least one MIPI device comprises a first MIPI device; and the at least one antenna comprises a first antenna;
a first end of the radio frequency module is coupled to a first end of the first radio frequency cable, and a second end of the first radio frequency cable is coupled to a first end of the first MIPI device; and a second end of the first MIPI device is coupled to the first antenna; and
the second end of the first radio frequency cable is further coupled to a first functional pin of the first MIPI device; and the first end of the first radio frequency cable is coupled to a reference ground.

2. The circuit assembly according to claim 1, further comprising: a baseband module, and a first register corresponding to the first MIPI device, wherein
a first end of the baseband module is coupled to a first end of the first register, and a second end of the baseband module is coupled to a second end of the radio frequency module; and a second end of the first register is coupled to a third end of the first MIPI device; and
when a first USID is the same as a second USID, first written data is the same as first read data, wherein
the first USID is a USID corresponding to a connection status of the first functional pin, and the second USID is a corresponding USID when the connection status of the first functional pin is grounded; and
the first written data is data written into the first register by the baseband module based on the second USID; and the first read data is data read by the baseband module from the first register based on the second USID.

3. The circuit assembly according to claim 2, wherein the first written data is different from the first read data when the first USID is different from the second USID.

4. The circuit assembly according to claim 2 or 3, wherein the first MIPI device is configured with first device information, and the first device information comprises the second USID.

5. The circuit assembly according to claim 4, wherein the first device information further comprises: information about a MIPI bus interface of the first MIPI device, and an identifier of a first register address of the first MIPI device.

6. The circuit assembly according to claim 4 or 5, wherein before that the baseband module writes the first written data into the first register,
the baseband module is further configured to search for the first register based on the first device information; and
the baseband module writes the first written data into the first register when the first register is found, wherein
when the first USID is the same as the second USID, it is determined that the first register is found.

7. The circuit assembly according to any one of claims 4 to 6, wherein after the baseband module writes the first written data into the first register and before the baseband module reads the data from the first register,
the baseband module is further configured to search for the first register based on the first device information; and
the baseband module reads written data from the first register when the first register is found, and the written data is the first read data, wherein
when the first USID is the same as the second USID, it is determined that the first register is found.

8. The circuit assembly according to claim 7, wherein when the first USID and the second USID in the first register are different, the first read data read by the baseband module comprises: an identifier of 0 or false.

9. The circuit assembly according to any one of claims 1 to 8, wherein the circuit assembly further comprises a first capacitor and a second capacitor;
the first end of the radio frequency module is coupled to the first end of the first radio frequency cable through the first capacitor; and
the second end of the first radio frequency cable is coupled to the first end of the first MIPI device through the second capacitor.

10. The circuit assembly according to any one of claims 1 to 9, wherein the circuit assembly further comprises a first inductor and a second inductor;
the second end of the first radio frequency cable is coupled to the first functional pin of the first MIPI device through the first inductor; and
the first end of the first radio frequency cable is coupled to the reference ground through the second inductor.

11. The circuit assembly according to any one of claims 1 to 10, wherein the circuit assembly further comprises a second radio frequency cable, and the at least one antenna further comprises a second antenna;
a third end of the radio frequency module is coupled to a first end of the second radio frequency cable, and a second end of the second radio frequency cable is coupled to the second antenna;
the second end of the second radio frequency cable is further coupled to the reference ground;
the first end of the second radio frequency cable is coupled to the first end of the first radio frequency cable; and
that the first end of the first radio frequency cable is coupled to the reference ground comprises: the first end of the first radio frequency cable being coupled to the reference ground through the second radio frequency cable.

12. The circuit assembly according to claim 11, wherein the circuit assembly further comprises a third capacitor and a fourth capacitor;
the third end of the radio frequency module is coupled to the first end of the second radio frequency cable through the third capacitor; and
the second end of the second radio frequency cable is coupled to the second antenna through the fourth capacitor.

13. The circuit assembly according to claim 11 or 12, wherein the circuit assembly further comprises a third inductor and a fourth inductor;
the first end of the second radio frequency cable is coupled to the first end of the first radio frequency cable through the third inductor; and
the second end of the second radio frequency cable is further coupled to the reference ground through the fourth inductor.

14. A circuit detection method, applied to an electronic device, wherein the electronic device is configured with the circuit assembly according to any one of claims 1 to 13; and
the method comprises:
obtaining first device information, wherein the first device information is device information of the first MIPI device;
writing first written data into the first register based on the first device information, wherein the first register corresponds to the first MIPI device;
reading data in the first register based on the first device information, to obtain first read data;
when the first written data is the same as the first read data, determining that the first end of the first radio frequency cable is coupled to the radio frequency module, and the second end of the first radio frequency cable is coupled to a first end of the first MIPI device; or
when the first written data is different from the first read data, determining that the first end of the first radio frequency cable is disconnected from the radio frequency module, and/or the second end of the first radio frequency cable is disconnected from the first end of the first MIPI device.

15. A chip system, used in an electronic device, wherein the chip system comprises one or more interface circuits and one or more processors; the interface circuit is connected to the processor through a line; the interface circuit is configured to receive a signal from a memory of the electronic device and send the signal to the processor, and the signal comprises computer instructions stored in the memory; and when the processor executes the computer instructions, the electronic device performs the method according to claim 14.

16. An electronic device, configured with the circuit assembly according to any one of claims 1 to 13.
